# EUROPEAN PATENT APPLICATION

(11) **EP 4 753 181 A1**
(43) Date of publication of application: **03.06.2026**
(21) Application number: 24861651.8
(22) Date of filing: 05.07.2024
(51) Int. Cl.: H04L 1/00

(54) **METHOD AND APPARATUS FOR PROCESSING DATA, AND COMMUNICATION SYSTEM**

(30) Priority: 04.09.2023 CN 202311139917
(71) Applicant: HUAWEI TECHNOLOGIES CO., LTD., Shenzhen 518129 (CN)
(72) Inventor: REN, Hao, Shenzhen, Guangdong 518129 (CN); HE, Xiang, Shenzhen, Guangdong 518129 (CN)
(74) Representative: Huawei European IPR
(86) International application number: PCT/CN2024/103846
(87) International publication number: WO 2025/050806

(57) **Abstract**

This application belongs to the field of communication technologies, and provides a data processing method, an apparatus, and a communication system. The method includes: obtaining a data sequence, where the data sequence includes a plurality of forward error correction (forward error correction, FEC) codewords; performing FEC decoding on at least one FEC codeword in the data sequence to obtain at least one decoded codeword; and finding a preset sequence in the at least one decoded codeword. Because a bit error ratio of the decoded codeword is low, time consumed in searching for the preset sequence in the at least one decoded codeword in the data sequence is short, so that efficiency, precision, and reliability of searching for the preset sequence in the data sequence can be improved.

## Description

This application claims priority to Chinese Patent Application No. 202311139917.5, filed on September 4, 2023 and entitled "DATA PROCESSING METHOD, APPARATUS, AND COMMUNICATION SYSTEM", which is incorporated herein by reference in its entirety.

### TECHNICAL FIELD

This application relates to the field of communication technologies, and in particular, to a data processing method, an apparatus, and a communication system.

### BACKGROUND

In the communication field, when a transmitter in an Ethernet (Ethernet) sends data to a receiver, the transmitter periodically inserts a preset sequence into the data, and the transmitter sends, to the receiver, a data sequence including the preset sequence. These periodic preset sequences may be used by the receiver to search for a codeword boundary in the received data sequence, may be used to pad the data sequence to a specific length, or the like. After the receiver receives the data sequence, the receiver finds the preset sequence in the data sequence, and decodes the data sequence after deleting the preset sequence from the data sequence.

However, due to impact of a channel loss and noise, bit errors inevitably occur in a process of transmitting the data sequence from the transmitter to the receiver, and the bit errors inevitably exist in the data sequence received by the receiver. These bit errors easily cause an increase in time consumed by the receiver in searching for the preset sequence in the data sequence, and even cause the receiver to fail to find a real preset sequence in the data sequence, affecting data processing of the receiver.

### SUMMARY

This application provides a data processing method, an apparatus, and a communication system, to shorten time consumed in searching for a preset sequence in a data sequence, and improve efficiency, precision, and reliability of searching for the preset sequence in the data sequence. Technical solutions of this application are as follows.

According to a first aspect, a data processing method is provided. The method includes: obtaining a data sequence, where the data sequence includes a plurality of forward error correction (forward error correction, FEC) codewords; performing FEC decoding on at least one FEC codeword in the data sequence to obtain at least one decoded codeword; and finding a preset sequence in the at least one decoded codeword.

According to the technical solution provided in this application, the preset sequence is searched for based on decoded data. Because error detection and error correction may be performed on the at least one FEC codeword in the data sequence in a process of performing FEC decoding on the at least one FEC codeword, the at least one decoded codeword obtained by performing FEC decoding on the at least one FEC codeword has a low bit error ratio or may even have no bit error. Therefore, searching for the preset sequence in the at least one decoded codeword has short consumed time, and high efficiency, precision, and reliability, so that transmission efficiency and reliability of a communication system can be ensured.

Optionally, the preset sequence is a sequence that periodically appears in the data sequence. A periodicity at which the preset sequence appears in the data sequence may be a strict periodicity, or may be a non-strict periodicity. Different strict periodicities are strictly equal, and different non-strict periodicities may be unequal. A difference between different non-strict periodicities is less than a preset difference. Optionally, the periodicity at which the preset sequence appears in the data sequence is a non-strict periodicity, and a rule in which the preset sequence appears in the data sequence is approximately periodic.

Optionally, the method includes: if a preset condition is satisfied, deleting, from the data sequence based on a position of the found preset sequence in the data sequence, a padding (pad or padding) sequence related to the preset sequence, where the preset condition includes: a quantity of preset sequences included in n codewords in the at least one decoded codeword reaches a first threshold, where n is a positive integer, and an interval between adjacent codewords in the n codewords is a periodicity at which the preset sequence appears in the data sequence. The padding sequence related to the preset sequence may be a padding sequence including the preset sequence.

Optionally, the method includes: if an unlock condition is satisfied, re-searching for an FEC codeword boundary in the data sequence, where the unlock condition includes: a quantity of codewords that are in m codewords in the at least one decoded codeword and that do not include the preset sequence reaches a second threshold, where m is a positive integer, and an interval between adjacent codewords in the m codewords is a periodicity at which the preset sequence appears in the data sequence.

According to the technical solution provided in this application, when the quantity of codewords that are in the m codewords in the at least one decoded codeword and that do not include the preset sequence reaches the second threshold, it may be considered that a locked FEC codeword boundary is incorrect, and the locked FEC codeword boundary is unlocked. Therefore, the FEC codeword boundary in the data sequence is re-searched for, so that FEC decoding is performed on the data sequence based on an FEC codeword boundary found again.

Optionally, the performing FEC decoding on the at least one FEC codeword in the data sequence to obtain the at least one decoded codeword includes: performing FEC decoding on the plurality of FEC codewords to obtain a plurality of decoded codewords. Correspondingly, the finding the preset sequence in the at least one decoded codeword includes: finding the preset sequence in the plurality of decoded codewords. Optionally, the preset sequence is sequentially searched for in the plurality of decoded codewords in an arrangement order of the plurality of decoded codewords, until a 1^{st} preset sequence is found. After the 1^{st} preset sequence is found, the preset sequence is searched for, based on the periodicity at which the preset sequence appears in the data sequence, in a codeword after the codeword in which the 1^{st} preset sequence is located. In other words, the 1^{st} preset sequence is searched for in the plurality of decoded codewords codeword by codeword, and after the 1^{st} preset sequence is found, the preset sequence is not searched for codeword by codeword, but the preset sequence is searched for in the plurality of decoded codewords based on the periodicity at which the preset sequence appears in the data sequence.

According to the technical solution provided in this application, the 1^{st} preset sequence is searched for codeword by codeword, and after the 1^{st} preset sequence is found, the preset sequence is searched for in the plurality of decoded codewords based on the periodicity at which the preset sequence appears in the data sequence. In this way, efficiency of searching for the preset sequence can be improved.

Optionally, the performing FEC decoding on the at least one FEC codeword in the data sequence to obtain the at least one decoded codeword, and the finding the preset sequence in the at least one decoded codeword include: performing FEC decoding on a first FEC codeword in the data sequence to obtain a decoded first codeword; and if the decoded first codeword does not include the preset sequence, continuing to perform FEC decoding on an FEC codeword that is in the data sequence and that is after the first FEC codeword, until a 1^{st} preset sequence is found. For example, the preset sequence is searched for in the decoded first codeword. If the preset sequence is not found in the decoded first codeword, the FEC decoding is sequentially performed, in an arrangement order of the FEC codewords in the data sequence, on FEC codewords that are in the data sequence and that are after the first FEC codeword, and the preset sequence is searched for in decoded codewords until the 1^{st} preset sequence is found. The first FEC codeword is an FEC codeword in the data sequence, for example, a 1^{st} FEC codeword in the data sequence.

Optionally, the performing FEC decoding on the at least one FEC codeword in the data sequence to obtain the at least one decoded codeword, and the finding the preset sequence in the at least one decoded codeword further include: if the decoded first codeword includes the preset sequence, performing FEC decoding on a second FEC codeword that is in the data sequence and that is after the first FEC codeword to obtain a decoded second codeword, where an interval between the second FEC codeword and the first FEC codeword is a periodicity at which the preset sequence appears in the data sequence; and attempting to search for the preset sequence in the decoded second codeword. In other words, the 1^{st} preset sequence is searched for in the data sequence FEC codeword by FEC codeword, and after the 1^{st} preset sequence is found, the preset sequence is not searched for FEC codeword by FEC codeword, but the preset sequence is searched for in the data sequence based on the periodicity at which the preset sequence appears in the data sequence.

According to the technical solution provided in this application, after the 1^{st} preset sequence is found in the data sequence, the preset sequence is attempted to be searched for in the data sequence based on the periodicity at which the preset sequence appears in the data sequence. In this way, efficiency of searching for the preset sequence can be improved.

Optionally, the performing FEC decoding on the at least one FEC codeword in the data sequence includes: performing FEC decoding on the first FEC codeword in the data sequence in a first decoding manner; and performing, in a second decoding manner, FEC decoding on a candidate FEC codeword that is in the data sequence and that is after the first FEC codeword. For example, in a preset sequence locking process, FEC decoding is performed on the FEC codeword (including the first FEC codeword and possibly including the second FEC codeword) in the data sequence in the first decoding manner, and after the preset sequence is locked, FEC decoding is performed on the candidate FEC codeword that is in the data sequence and that is after the first FEC codeword in the second decoding manner. The candidate FEC codeword includes all undecoded FEC codewords in the data sequence after the preset sequence is locked.

According to the technical solution provided in this application, the first decoding manner is different from the second decoding manner, and the decoding manner used in the preset sequence locking process is different from the decoding manner used after the preset sequence is locked. This can increase an application scope of this application.

Optionally, the first decoding manner is soft-decision decoding (soft-decision decoding, SDD), and the second decoding manner is hard-decision decoding (hard-decision decoding, HDD). Alternatively, the first decoding manner is HDD, and the second decoding manner is SDD. Optionally, in the preset sequence locking process, FEC decoding is performed on the FEC codeword in the data sequence through SDD, and after the preset sequence is locked, FEC decoding is performed on the FEC codeword in the data sequence through HDD. Alternatively, in the preset sequence locking process, FEC decoding is performed on the FEC codeword in the data sequence through HDD, and after the preset sequence is locked, FEC decoding is performed on the FEC codeword in the data sequence through SDD. HDD has low decoding complexity, and SDD decoding has good performance. Formal data processing is performed on the data sequence after the preset sequence is locked, and the formal data processing includes performing FEC decoding on the FEC codeword in the data sequence. In other words, after the preset sequence is locked, a process of performing FEC decoding on the FEC codeword in the data sequence is a process of performing formal data processing on the data sequence.

According to the technical solution provided in this application, when the first decoding manner is HDD and the second decoding manner is SDD, FEC decoding is performed on the FEC codeword in the data sequence through HDD in the preset sequence locking process, and FEC decoding is performed on the FEC codeword in the data sequence through SDD after the preset sequence is locked. In this way, complexity of locking the preset sequence can be reduced, and bit error performance of the formal data processing can be ensured. When the first decoding manner is SDD and the second decoding manner is HDD, FEC decoding is performed on the FEC codeword in the data sequence through SDD in the preset sequence locking process, and FEC decoding is performed on the FEC codeword in the data sequence through HDD after the preset sequence is locked. In this way, reliability of locking the preset sequence can be improved, and complexity of the formal data processing can be reduced.

Optionally, the first decoding manner and the second decoding manner are implemented using same hardware logic, so that implementation complexity and implementation costs can be reduced.

Optionally, before performing FEC decoding on the at least one FEC codeword in the data sequence, the method further includes: determining the FEC codeword boundary in the data sequence in a self-synchronization manner.

According to the technical solution provided in this application, the FEC codeword boundary in the data sequence is determined in the self-synchronization manner, so that a technical effect of high-precision codeword synchronization can be implemented, and reliability of the FEC codeword boundary determined in the self-synchronization manner is high.

Optionally, the preset sequence is a frame sequence (frame sequence, FS), or the preset sequence is in an alignment marker (alignment marker, AM). Therefore, the technical solutions of this application can be interoperable with the Institute of Electrical and Electronics Engineers (Institute of Electrical and Electronics Engineers, IEEE) 802.3dj standard and the 200/400 gigabit Ethernet (gigabit Ethernet, GE) standard.

Optionally, the preset sequence is an FS, the padding sequence related to the preset sequence is a padding sequence in the IEEE802.3dj standard, the preset sequence is located at the beginning of the padding sequence related to the preset sequence, and a length of the padding sequence is an integer multiple of a length of the FEC codeword in the data sequence.

Optionally, the method is performed by a host chip (host chip), an optical module, or a chip in the optical module. The optical module may be a pluggable optical module.

Optionally, the data sequence is obtained based on an Ethernet signal received through an Ethernet interface.

Optionally, the Ethernet signal is a Terabit Ethernet (Terabit Ethernet, TbE) signal.

According to a second aspect, a data processing apparatus is provided. The apparatus is configured to perform the method according to any one of the first aspect or the optional implementations of the first aspect.

Optionally, the apparatus includes an Ethernet interface. The Ethernet interface may be a Terabit Ethernet interface.

Optionally, the apparatus is any one of the following: a forwarding device, a user terminal device, a server device, a host chip (host chip), an optical module, or a chip in the optical module. The forwarding device may be a router or a switch.

In an implementation, the apparatus includes at least one module, and the at least one module is configured to perform the method according to any one of the first aspect or the optional manners of the first aspect. The at least one module may be implemented based on software, hardware, or a combination of software and hardware, and the at least one module may be randomly combined or divided based on a specific implementation.

Optionally, the apparatus includes:
an obtaining module, configured to obtain a data sequence, where the data sequence includes a plurality of forward error correction FEC codewords;
a decoding module, configured to perform FEC decoding on at least one FEC codeword in the data sequence to obtain at least one decoded codeword; and
a searching module, configured to find a preset sequence in the at least one decoded codeword.

Optionally, the preset sequence is a sequence that periodically appears in the data sequence.

Optionally, the apparatus further includes a deletion module, configured to: if a preset condition is satisfied, delete, from the data sequence based on a position of the found preset sequence in the data sequence, a padding sequence related to the preset sequence, where the preset condition includes: a quantity of preset sequences included in n codewords in the at least one decoded codeword reaches a first threshold, where n is a positive integer, and an interval between adjacent codewords in the n codewords is a periodicity at which the preset sequence appears in the data sequence.

Optionally, the apparatus further includes a synchronization module, configured to: if an unlock condition is satisfied, re-search for an FEC codeword boundary in the data sequence, where the unlock condition includes: a quantity of codewords that are in m codewords in the at least one decoded codeword and that do not include the preset sequence reaches a second threshold, where m is a positive integer, and an interval between adjacent codewords in the m codewords is a periodicity at which the preset sequence appears in the data sequence.

Optionally, the decoding module is configured to perform FEC decoding on the plurality of FEC codewords to obtain a plurality of decoded codewords; and
correspondingly, the searching module is configured to find the preset sequence in the plurality of decoded codewords.

Optionally, the decoding module is configured to:
perform FEC decoding on a first FEC codeword in the data sequence to obtain a decoded first codeword; and
if the decoded first codeword does not include the preset sequence, continue to perform FEC decoding on an FEC codeword that is in the data sequence and that is after the first FEC codeword, until a 1^{st} preset sequence is found.

Optionally, the decoding module is further configured to: if the decoded first codeword includes the preset sequence, perform FEC decoding on a second FEC codeword that is in the data sequence and that is after the first FEC codeword to obtain a decoded second codeword, where an interval between the second FEC codeword and the first FEC codeword is a periodicity at which the preset sequence appears in the data sequence; and
correspondingly, the searching module is configured to attempt to search for the preset sequence in the decoded second codeword.

Optionally, the decoding module is configured to: perform FEC decoding on the first FEC codeword in the data sequence in a first decoding manner; and perform, in a second decoding manner, FEC decoding on a candidate FEC codeword that is in the data sequence and that is after the first FEC codeword.

Optionally, the first decoding manner is soft-decision decoding, and the second decoding manner is hard-decision decoding; or
the first decoding manner is hard-decision decoding, and the second decoding manner is soft-decision decoding.

Optionally, the apparatus further includes a synchronization module, configured to determine the FEC codeword boundary in the data sequence in a self-synchronization manner.

Optionally, the preset sequence is a frame sequence FS, or the preset sequence is in an alignment marker AM.

Optionally, the data sequence is obtained based on an Ethernet signal received through the Ethernet interface.

Optionally, the Ethernet signal is a Terabit Ethernet Terabit Ethernet signal.

In another implementation, the apparatus includes a memory, a processor, and a communication interface, where the communication interface includes an Ethernet interface; and
the memory is configured to store a computer program; and the processor is configured to execute the computer program stored in the memory, to cause the apparatus to perform related steps in the method according to any one of the first aspect or the optional manners of the first aspect.

Optionally, the processor is configured to execute the computer program stored in the memory, to cause the apparatus to perform the following operation: finding a preset sequence in at least one decoded codeword, where the at least one decoded codeword is obtained by performing FEC decoding on at least one forward error correction FEC codeword in a data sequence, and the data sequence includes a plurality of FEC codewords.

Optionally, the processor is further configured to execute the computer program stored in the memory, to cause the apparatus to perform the following operation: if a preset condition is satisfied, delete, from the data sequence based on a position of the found preset sequence in the data sequence, a padding sequence related to the preset sequence, where the preset condition includes: a quantity of preset sequences included in n codewords in the at least one decoded codeword reaches a first threshold, where n is a positive integer, and an interval between adjacent codewords in the n codewords is a periodicity at which the preset sequence appears in the data sequence.

According to a third aspect, a chip is provided. The chip is configured to perform the method according to any one of the first aspect or the optional manners of the first aspect.

Optionally, the chip is a chip in a host chip or an optical module, and the chip includes a programmable logic circuit and/or program instructions.

According to a fourth aspect, a computer-readable storage medium is provided. The computer-readable storage medium stores a computer program. When the computer program is executed, a preset sequence is found in at least one decoded codeword, where the at least one decoded codeword is obtained by performing FEC decoding on at least one forward error correction FEC codeword in a data sequence, and the data sequence includes a plurality of FEC codewords.

Optionally, when the computer program is executed, if a preset condition is satisfied, a padding sequence related to the preset sequence is deleted from the data sequence based on a position of the found preset sequence in the data sequence, where the preset condition includes: a quantity of preset sequences included in n codewords in the at least one decoded codeword reaches a first threshold, where n is a positive integer, and an interval between adjacent codewords in the n codewords is a periodicity at which the preset sequence appears in the data sequence.

According to a fifth aspect, a computer program product is provided. The computer program product includes a program or code. When the program or code is executed, a preset sequence is found in at least one decoded codeword, where the at least one decoded codeword is obtained by performing FEC decoding on at least one forward error correction FEC codeword in a data sequence, and the data sequence includes a plurality of FEC codewords.

Optionally, when the program or the code is executed, if a preset condition is satisfied, a padding sequence related to the preset sequence is deleted from the data sequence based on a position of the found preset sequence in the data sequence, where the preset condition includes: a quantity of preset sequences included in n codewords in the at least one decoded codeword reaches a first threshold, where n is a positive integer, and an interval between adjacent codewords in the n codewords is a periodicity at which the preset sequence appears in the data sequence.

According to a sixth aspect, a communication system is provided. The system includes an optical module and a host, where the optical module is communicatively connected to the host, for example, the optical module is inserted into the host, and the optical module is configured to perform the method according to any one of the first aspect or the optional manners of the first aspect.

Optionally, the host is a forwarding device, a user terminal device, or a server device. The forwarding device is a router or a switch.

In the technical solutions provided in this application, because the optical module is configured to perform the method according to any one of the first aspect or the optional manners of the first aspect, efficiency, precision, and reliability of searching for a preset sequence in a data sequence can be improved by performing the foregoing method by the optical module. Therefore, the host connected to the optical module can obtain a corresponding benefit, for example, efficiency and reliability of processing the data sequence by the host are improved.

For technical effects of the second aspect to the sixth aspect that are not described, refer to the technical effects of the first aspect. Details are not described herein again.

### BRIEF DESCRIPTION OF DRAWINGS

FIG. 1 is a diagram of sending data at a physical layer;
FIG. 2 is a diagram of an application scenario according to an embodiment of this application;
FIG. 3 is a diagram of a data sequence according to an embodiment of this application;
FIG. 4 is a diagram of another data sequence according to an embodiment of this application;
FIG. 5 is a diagram of still another data sequence according to an embodiment of this application;
FIG. 6 is a diagram of yet another data sequence according to an embodiment of this application;
FIG. 7 is a diagram of another application scenario according to an embodiment of this application;
FIG. 8 is a diagram of still another application scenario according to an embodiment of this application;
FIG. 9 is a diagram of yet another application scenario according to an embodiment of this application;
FIG. 10 is a diagram of yet another application scenario according to an embodiment of this application;
FIG. 11 is a flowchart of a data processing method according to an embodiment of this application;
FIG. 12 is a flowchart of another data processing method according to an embodiment of this application;
FIG. 13 is a diagram of a data processing method according to an embodiment of this application;
FIG. 14 is a state diagram of a preset sequence locking process according to an embodiment of this application;
FIG. 15 is a state diagram of a preset sequence monitoring process according to an embodiment of this application;
FIG. 16 is a diagram of a data processing apparatus according to an embodiment of this application;
FIG. 17 is a diagram of another data processing apparatus according to an embodiment of this application; and
FIG. 18 is a diagram of still another data processing apparatus according to an embodiment of this application.

### DESCRIPTION OF EMBODIMENTS

The following further describes in detail embodiments of this application with reference to accompanying drawings.

A synchronization (synchronization) technology is an important technology in the communication field, and the synchronization technology is used in many scenarios. Based on different implementation objectives, synchronization may be classified into a plurality of types such as clock synchronization, carrier synchronization, bit synchronization, and frame synchronization (frame synchronization). Clock synchronization is to ensure time consistency between different devices. Carrier synchronization is a process in which a receiver obtains a coherent carrier from a received signal in coherent optical transmission. Bit synchronization is a process in which a receiver extracts a clock signal from a received signal to make a correct sampling decision of an information symbol. Frame synchronization is a process in which a receiver identifies a start or an end of a specific data block from a received data sequence (or referred to as a data stream). For example, the data sequence received by the receiver includes a plurality of codewords (codeword, CW). Frame synchronization is a process in which the receiver identifies a start or an end of the codeword from the data sequence. The start and the end of the codeword are also referred to as codeword boundaries. Therefore, frame synchronization is a process in which the receiver identifies the codeword boundary from the received data sequence. Optionally, the data sequence received by the receiver is a data sequence on which forward error correction (forward error correction, FEC) encoding is performed, a codeword in the data sequence is an FEC codeword, and frame synchronization is a process in which the receiver identifies an FEC codeword boundary from the data sequence. The FEC codeword boundary is also a codeword boundary of the FEC codeword, and is also referred to as a boundary of the FEC codeword. In some implementation scenarios, frame synchronization is also referred to as codeword synchronization (codeword synchronization), and a codeword boundary in a data sequence is also referred to as a synchronization position (synchronization position).

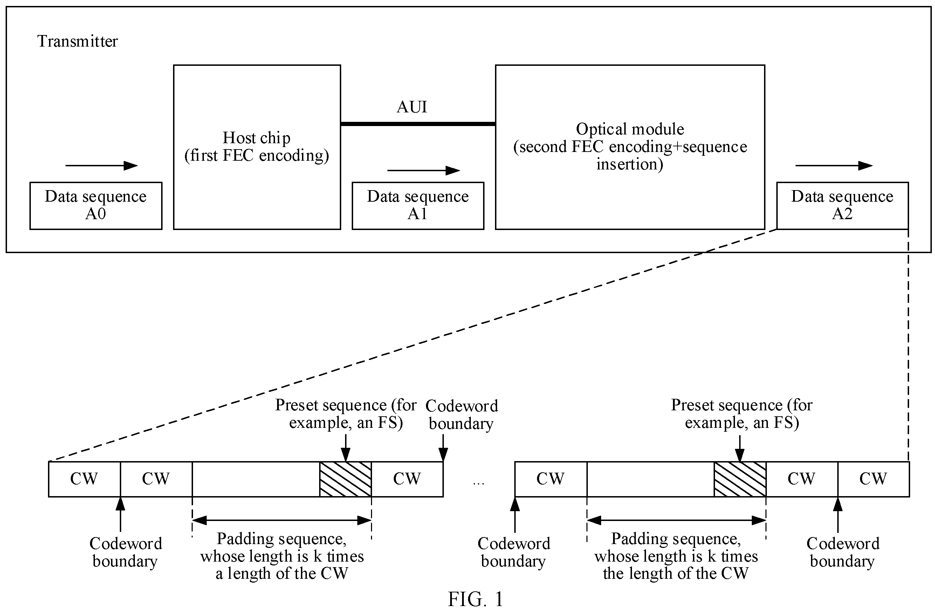

In the communication field, when a transmitter in an Ethernet (Ethernet) sends data to a receiver, the transmitter periodically inserts a preset sequence into the data, and the transmitter sends, to the receiver, a data sequence including the preset sequence. These periodic preset sequences may be used by the receiver to search for a codeword boundary in the received data sequence, may be used to pad the data sequence to a specific length, or the like. After the receiver receives the data sequence, the receiver finds the preset sequence in the data sequence, and decodes the data sequence after deleting the preset sequence from the data sequence. FIG. 1 is a diagram of sending data at a physical layer in the Institute of Electrical and Electronics Engineers (Institute of Electrical and Electronics Engineers, IEEE) 802.3dj standard project. As shown in FIG. 1, a transmitter includes a host chip (host chip) and an optical module. The host chip is connected to the optical module through an attachment unit interface (attachment unit interface, AUI). When the transmitter sends a data sequence A0, the host chip first performs first FEC encoding on the data sequence A0 to obtain a data sequence A1, the host chip sends the data sequence A1 to the optical module through the AUI, the optical module performs second FEC encoding on the data sequence A1 and periodically inserts a padding (pad or padding) sequence into the data sequence A1 to obtain a data sequence A2, and the optical module sends the data sequence A2 to a receiver. The data sequence A2 includes a plurality of codewords (codeword, CW) and a plurality of padding sequences. Each of the plurality of CWs is an FEC codeword obtained through the second FEC encoding. Optionally, the optical module further interleaves the FEC codewords obtained through the second FEC encoding. In this case, each CW in the data sequence A2 is an interleaved codeword block obtained by interleaving the FEC codeword (namely, an equal-length data block obtained by interleaving the FEC codeword). The optical module may not interleave the FEC codewords obtained through the second FEC encoding. This is not limited in embodiments of this application. The plurality of padding sequences periodically appear in the data sequence A2, and each of the plurality of padding sequences includes a preset sequence known to both the transmitter and the receiver. For example, in discussion of the IEEE802.3dj standard, the preset sequence is referred to as a frame sequence (frame sequence, FS). The preset sequence in each padding sequence is located at the beginning of the padding sequence, and a start position of the preset sequence in each padding sequence is the same as a start position of the padding sequence. The padding sequence also undergoes the second FEC encoding and the possible interleaving. A length of each padding sequence is an integer multiple of a length of the CW (in FIG. 1, k times are as an example for description, where k is a positive integer, for example, k=2). Therefore, it may be considered that each padding sequence includes an integer quantity of padding CWs (padding CW), and the padding CW may also be referred to as a virtual CW or an analog CW. The integer quantity of padding CWs are additionally inserted by the transmitter into the data sequence that needs to be sent. For example, the CW is an FEC codeword obtained through the second FEC encoding, and the optical module inserts three padding codewords (the padding codeword is also an FEC codeword, in other words, the length of the padding sequence is three times a length of the FEC codeword) at an interval of 3264 FEC codewords, or inserts eight padding codewords (the padding codeword is also an FEC codeword, in other words, the length of the padding sequence is eight times a length of the FEC codeword) at an interval of 8704 FEC codewords.

After the receiver receives the data sequence A2, the receiver needs to find a codeword boundary in the data sequence A2 to perform second FEC decoding (namely, FEC decoding corresponding to the second FEC encoding) on the data sequence A2. For example, when the CW in the data sequence A2 is an FEC codeword obtained by performing second FEC encoding, the codeword boundary is a boundary of the CW in FIG. 1, and the codeword boundary is an FEC codeword boundary. When the CW in the data sequence A2 is an interleaved codeword block obtained by interleaving the FEC codeword obtained by performing second FEC encoding, the receiver first de-interleaves the data sequence A2, and then searches for the codeword boundary in the data sequence A2. Because the padding sequence is additionally inserted non-media access control (media access control, MAC) data, the receiver further needs to find the padding sequence in the data sequence A2 to delete the padding sequence. The receiver may search for the preset sequence known to the receiver in the data sequence A2, to search for the padding sequence including the preset sequence in the data sequence A2. The receiver may search for the codeword boundary in the data sequence A2 by performing codeword synchronization on the data sequence A2. Herein, an example in which the CW in the data sequence A2 is an FEC codeword that is obtained by performing second FEC encoding and that is not interleaved is used for description. After the receiver finds the codeword boundary in the data sequence A2, the receiver determines the CW in the data sequence A2 based on the codeword boundary in the data sequence A2, and performs second FEC decoding on the CW in the data sequence A2. Optionally, after the receiver performs second FEC decoding on the data sequence A2 to obtain the data sequence A1, the receiver further performs first FEC decoding (namely, FEC decoding corresponding to the first FEC encoding) on the data sequence A1 to obtain the data sequence A0. It should be noted that the first FEC encoding, the second FEC encoding, the first FEC decoding, and the second FEC decoding are used as examples herein for description. In some implementation scenarios or documents, the first FEC encoding herein is also described as outer FEC encoding or outer encoding, the second FEC encoding herein is also described as inner FEC encoding or inner encoding, the first FEC decoding herein is also described as outer FEC decoding or outer decoding, and the second FEC decoding herein is also described as inner FEC decoding or inner decoding. This is not limited in embodiments of this application.

A codeword synchronization solution is mentioned in the discussion of the IEEE802.3dj standard. In the following descriptions, an example in which a receiver searches for a codeword boundary in a data sequence A2 according to the codeword synchronization solution is used for description, and an example in which a CW in the data sequence A2 is an FEC codeword that is obtained through second FEC encoding and that is not interleaved. In a description process, a preset sequence in the data sequence A2 is described as an FS. The receiver first searches for the FS in the data sequence A2 based on an FS known to the receiver, and then determines the codeword boundary in the data sequence A2 based on the FS found in the data sequence A2. A process in which the receiver searches for the FS in the data sequence A2 based on the FS known to the receiver includes an FS locking process and an FS monitoring process. Specifically, the FS locking process includes: The receiver compares, with the data sequence A2 bit by bit, the FS known to the receiver to search for the FS in the data sequence A2. After the receiver finds a 1^{st} FS in the data sequence A2, the receiver searches for the FS in the data sequence A2 based on the 1^{st} FS and a periodicity at which the FS appears in the data sequence A2. If a quantity of FSs continuously found by the receiver in the data sequence A2 reaches a specified quantity (for example, 3), the receiver considers that the 1^{st} found FS is a real FS, and the receiver locks the 1^{st} FS. The FS monitoring process includes: After the receiver locks the 1^{st} FS, the receiver determines a potential FS position in the data sequence A2 based on a target FS found in the FS locking process (for example, the target FS is a last FS found in the FS locking process) and the periodicity at which the FS appears in the data sequence A2, and the receiver verifies whether data content at the potential FS position matches content of the FS known to the receiver. If data content at a specific potential FS position matches the content of the known FS, the receiver determines that the data content at the potential FS position is an FS (in other words, the receiver finds an FS), and the receiver successfully verifies the potential FS position. If the receiver fails to verify a plurality of potential FS positions that continuously appear, the receiver determines that the 1^{st} locked FS is unlocked, and the receiver re-performs FS locking (in other words, re-performs the FS locking process) on the data sequence A2, and performs FS monitoring (in other words, re-performs the FS monitoring process) on the data sequence A2 based on a re-locked FS. In this way, a closed-loop procedure of FS locking-FS monitoring-FS locking is formed. After the receiver locks the FS in the data sequence A2, the receiver determines the codeword boundary in the data sequence A2 based on the locked FS in the data sequence A2. The potential FS position is a position at which the FS may appear. The potential FS position is an area, in the data sequence A2, whose length is equal to a length of the FS. For example, if the target FS is between a1^{th} and (a1 +48)^{th} bits, and the periodicity at which the FS appears is (3264* 128+3*128) bits, potential FS positions are between [a1+(3264*128+3*128)]^{th} and [(a1+48)+(3264*128+3*128)]^{th} bits, between [a1+2*(3264*128+3*128)]^{th} and [(a1+48)+2*(3264*128+3*128)]^{th} bits, ..., where 3264*128 bits are a periodicity at which a padding sequence appears in the data sequence A2, and 3*128 is a length of the padding sequence. For another example, if the periodicity at which the FS appears is (8704*128+8*128) bits, potential FS positions are between [a1+(8704*128+8*128)]^{th} and [(a1+48)+(8704*128+8*128)]^{th} bits, between [a1+2*(8704*128+8*128)]^{th} and [(a1+48)+2*(8704*128+8*128)]^{th} bits, ..., where 8704* 128 bits are an interval between padding sequences, and 8*128 is a length of the padding sequence.

A codeword synchronization solution is also mentioned in the 200/400 gigabit Ethernet (gigabit Ethernet, GE) standard defined in the IEEE802.3bs project. A difference between the codeword synchronization solution and the foregoing codeword synchronization solution mentioned in the discussion of the IEEE802.3dj standard lies in that the padding sequence is replaced with an alignment marker (alignment marker, AM). Specifically, when a transmitter sends a data sequence B0, the transmitter performs FEC encoding on the data sequence B0 and periodically inserts an AM into the data sequence B0 to obtain a data sequence B1, and the transmitter sends the data sequence B1 to a receiver. The data sequence B1 includes a plurality of CWs and a plurality of AMs. Each of the plurality of CWs is an FEC codeword obtained through the FEC encoding. Optionally, the transmitter further interleaves the FEC codewords obtained through the FEC encoding. In this case, each CW in the data sequence B1 is an interleaved codeword block obtained by interleaving the FEC codeword. The transmitter may not interleave the FEC codeword obtained through the FEC encoding. This is not limited in embodiments of this application. The plurality of AMs periodically appear in the data sequence B1, each of the plurality of AMs includes a preset sequence known to both the transmitter and the receiver, and the AM also undergoes the FEC encoding and the possible interleaving. An example in which the CW in the data sequence B1 is an FEC codeword obtained through the FEC encoding and is not interleaved is used for description. After the receiver receives the data sequence B1, the receiver searches for an AM in the data sequence B1 based on the preset sequence known to the receiver. For example, the receiver searches for the preset sequence in the data sequence B1 based on the preset sequence known to the receiver; the receiver finds, based on the found preset sequence, an AM including the preset sequence; and the receiver determines a codeword boundary in the data sequence B1 based on the AM found in the data sequence B1. A process in which the receiver searches for the AM in a data sequence A2 based on the preset sequence known to the receiver includes an AM locking process and an AM monitoring process. Specifically, the AM locking process includes: The receiver compares, with the data sequence B1 bit by bit, the preset sequence known to the receiver to search for the AM in the data sequence B1. After the receiver finds a 1^{st} AM in the data sequence B1, the receiver searches for the AM in the data sequence B1 based on the 1^{st} AM and a periodicity at which the AM appears in the data sequence B1. If a quantity of AMs continuously found by the receiver in the data sequence B1 reaches a specified quantity (for example, 3), the receiver considers that the 1^{st} found AM is a real AM, and the receiver locks the 1^{st} AM. The AM monitoring process includes: After the receiver locks the 1^{st} AM, the receiver determines a potential AM position in the data sequence B1 based on a target AM found in the AM locking process (for example, the target AM is a last AM found in the AM locking process) and the periodicity at which the AM appears in the data sequence B1, and the receiver verifies whether data content at the potential AM position matches content of the preset sequence known to the receiver. If data content at a specific potential AM position matches the content of the known preset sequence, the receiver determines that the data content at the potential AM position is an AM (in other words, the receiver finds an AM in the data sequence B1), and the receiver successfully verifies the potential AM position. If the receiver fails to verify a plurality of potential AM positions that continuously appear, the receiver determines that the 1^{st} locked AM is unlocked, and the receiver re-performs AM locking (in other words, re-performs the AM locking process) on the data sequence B1, and the receiver performs AM monitoring (in other words, re-performs the AM monitoring process) on the data sequence B1 based on a re-locked AM. In this way, a closed-loop procedure of AM locking-AM monitoring-AM locking is formed. After the receiver locks the AM in the data sequence B1, the receiver determines the codeword boundary in the data sequence B1 based on the locked AM in the data sequence B1. The potential AM position is a position at which the AM may appear. The potential AM position is an area, in the data sequence B1, whose length is equal to a length of the AM. For example, if the target AM is between b1^{th} and (b1+1028)^{th} bits, and the periodicity at which the AM appears is 4096*5440 bits, the potential AM position is between (b1+4096*5440)^{th} and [(b1+1028)+4096*5440]^{th} bits, between (b1+2*4096*5440)^{th} and [(b1+1028)+2*4096*5440]^{th} bits, ..., where 1028 is the length of the AM. For another example, if the target AM is between b1^{th} and (b1+1028)^{th} bits, and the periodicity at which the AM appears is 2*4096*5440 bits, the potential AM position is between (b1+2*4096*5440)^{th} and [(b1+1028)+2*4096*5440]^{th} bits, between (b1+2*2*4096*5440)^{th} and [(b1+1028)+2*2*4096*5440]^{th} bits, .... After the receiver finds the codeword boundary in the data sequence B1, the receiver determines the codeword (for example, the foregoing CW) in the data sequence B1 based on the codeword boundary in the data sequence B1, and performs FEC decoding on the codeword in the data sequence B1. In the codeword synchronization solution mentioned in the 200/400GE standard defined in the IEEE802.3bs project, in a process in which the receiver performs FEC decoding on the data sequence B1, the receiver continuously performs uncorrectable codeword monitoring on the data sequence B1. If a quantity of uncorrectable codewords (namely, codewords whose errors cannot be corrected) that continuously appear in the data sequence B1 reaches a preset quantity, or a proportion of uncorrectable codewords that continuously appear in the data sequence B1 reaches a preset ratio, the receiver considers that a currently locked AM is unlocked, and the receiver re-performs AM locking on the data sequence B1. The receiver performs AM monitoring on the data sequence B1 based on a re-locked AM, and the receiver re-determines a codeword boundary in the data sequence B1 based on the re-locked AM, and performs FEC decoding on the data sequence B1 based on the re-determined codeword boundary.

It can be learned from the foregoing descriptions that, regardless of the foregoing codeword synchronization solution mentioned in the discussion of the IEEE802.3dj standard or the foregoing codeword synchronization solution mentioned in the 200/400GE standard defined in the IEEE802.3bs project, additional data (for example, the FS in the discussion of the IEEE802.3dj standard or the AM in the 200/400GE standard defined in the IEEE802.3bs project) needs to be inserted into a data sequence to find a codeword boundary in the data sequence. It can be learned from the foregoing descriptions that, a process in which the receiver searches for (or identifies) a codeword boundary in a data sequence is referred to as codeword synchronization (or frame synchronization). In embodiments of this application, a synchronization solution in which a codeword boundary in a data sequence is searched for or identified by using additional data, such as an FS or an AM, that is inserted into the data sequence is referred to as a non-self-synchronization solution. Therefore, the foregoing codeword synchronization solution mentioned in the discussion of the IEEE802.3dj standard and the foregoing codeword synchronization solution mentioned in the 200/400GE standard defined in the IEEE802.3bs project are both non-self-synchronization solutions. In the non-self-synchronization solution, a codeword boundary in a data sequence can be found only by using additional data inserted into the data sequence. Consequently, searching for the codeword boundary in the data sequence has low precision, long consumed time, low efficiency, and low reliability.

Specifically, in the foregoing codeword synchronization solution mentioned in the discussion of the IEEE802.3dj standard, both the FS locking and the FS monitoring are performed based on a data sequence before decoding, in other words, the receiver searches for an FS in the data sequence before the decoding, and then searches for a codeword boundary based on the found FS. Because bit errors inevitably occur in a process of transmitting a data sequence from the transmitter to the receiver, the bit errors inevitably exist in the data sequence before the decoding, and a bit error ratio of the data sequence before the decoding may be high. For example, a bit error ratio (bit error ratio, BER) of the data sequence before the decoding is high. This easily causes an increase in time consumed by the receiver to search for the FS, and even causes the receiver to fail to find a real FS. Consequently, efficiency, stability, and reliability of searching for the codeword boundary by the receiver are all low. For example, bit errors in the FS in the data sequence A2 easily cause the receiver to fail to find a real FS in the FS locking process, and miss the real FS. Consequently, time consumed in the FS locking process is long, and a probability that the receiver incorrectly locks the FS is increased. For another example, bit errors in the FS in the data sequence A2 easily cause the receiver to fail to verify an original correct FS position in the FS monitoring process, and consequently, the FS locking and the FS monitoring need to be re-performed. Bit errors in the data sequence A2 easily cause the receiver to repeatedly perform FS locking and FS monitoring on the data sequence A2. This affects the receiver in searching for the codeword boundary, thereby affecting subsequent processing of the receiver on the data sequence, and affecting transmission efficiency of a communication system.

Specifically, in the codeword synchronization solution mentioned in the 200/400GE standard defined in the IEEE802.3bs project, both the AM locking and the AM monitoring are performed based on a data sequence before decoding, in other words, the receiver searches for an AM in the data sequence before the decoding, and then searches for a codeword boundary based on the found AM. Because bit errors inevitably exist in the data sequence before the decoding, and a bit error ratio of the data sequence before the decoding may be high, this easily causes an increase in time consumed by the receiver to search for the AM, and even causes the receiver to fail to find a real AM. Consequently, efficiency, stability, and reliability of searching for the codeword boundary by the receiver are all low. In addition, in the codeword synchronization solution mentioned in the 200/400GE standard, additional check logic (for example, an additional hardware circuit) needs to be added to perform uncorrectable codeword monitoring. An implementation process is complex and implementation costs are high.

In addition to the foregoing two codeword synchronization solutions, a self-synchronization (self-synchronization, self-sync) solution may alternatively be used to search for a codeword boundary in a data sequence. A receiver searches for a preset sequence (for example, an FS) in a data sequence based on a codeword boundary found by the receiver in the data sequence according to the self-synchronization solution, to find a padding sequence including the preset sequence and delete the padding sequence. In addition, the receiver determines a codeword in the data sequence based on the codeword boundary found in the data sequence, and then decodes the codeword in the data sequence.

Self-synchronization is a process in which a receiver searches for or identifies a codeword boundary in a data sequence based on an intrinsic characteristic or feature (intrinsic feature) of the data sequence. In the self-synchronization solution, the receiver searches for or identifies the codeword boundary in the data sequence without using additional data, such as an FS or an AM, that is inserted into the data sequence. In an embodiment, after a receiver receives a data sequence, the receiver attempts to divide the data sequence based on a length (for example, 128 bits), of a codeword in the data sequence, that is known to the receiver, and decodes a test data block obtained through the division. A length of the test data block is the length of the codeword. The receiver determines, based on a decoding result of the test data block, whether a division position at which the data sequence is divided is a codeword boundary. It should be noted that, because the receiver attempts to divide the data sequence to obtain the test data block whose length is equal to the length of the codeword, the test data block obtained by the receiver through the division may be a real codeword, or may not be a real codeword. For example, when the division position is exactly the codeword boundary, the test data block obtained through the division is a real codeword; or when the division position is not the codeword boundary, the test data block obtained through the division is not a real codeword. Because the length of the test data block obtained through the division is equal to the length of the codeword, for brevity, the test data block obtained through the division is described as a "codeword". For example, the receiver divides the data sequence into a plurality of codewords based on a codeword length (namely, the length of the codeword in the data sequence) known to the receiver, and the receiver decodes the plurality of codewords. The receiver determines a quantity of uncorrectable codewords in the plurality of codewords based on a decoding result. If the quantity of uncorrectable codewords in the plurality of codewords does not reach a preset quantity, or a proportion of the quantity of uncorrectable codewords in the plurality of codewords (for example, a ratio of the quantity of uncorrectable codewords in the plurality of codewords to a quantity of the plurality of codewords) does not reach a preset ratio, the receiver determines that a division position at which the data sequence is divided into the codewords is the codeword boundary, in other words, the receiver finds the codeword boundary in the data sequence. If the quantity of uncorrectable codewords in the plurality of codewords reaches the preset quantity, or a proportion of the quantity of uncorrectable codewords in the plurality of codewords reaches a preset ratio, the receiver determines that the division position at which the data sequence is divided into the codewords is not the codeword boundary, and the receiver re-divides the data sequence into codewords based on the codeword length known to the receiver, decodes the codewords obtained through the re-division, and determines, based on a decoding result, whether the division position at which the data sequence is re-divided into the codewords is the codeword boundary. The process is repeated until the codeword boundary is found. In addition, only an example of the self-synchronization solution is described herein. For a specific implementation of the self-synchronization solution, refer to the patent application document "CODEWORD SYNCHRONIZATION METHOD, RECEIVER, NETWORK DEVICE, AND NETWORK SYSTEM" with the publication number CN113517949A, and refer to the standard document "INNER CODEWORD SELF-SYNC PROPOSAL" (address: https://www.ieee802.org/3/dj/public/2307/he_3dj_03b_2307.pdf). Both of which are incorporated herein by reference in their entireties as if they were all stated. Details of the self-synchronization solution are not described in this specification.

Specifically, in the self-synchronization solution, after receiving a data sequence, the receiver searches the data sequence for a codeword boundary in a self-synchronization manner. After finding the codeword boundary in the data sequence, the receiver locks the codeword boundary in the data sequence. The receiver searches the data sequence for a preset sequence (for example, an FS) based on the locked codeword boundary. Specifically, the receiver first performs preset sequence locking on the data sequence based on the locked codeword boundary, and then performs preset sequence monitoring on the data sequence based on the locked codeword boundary and a locked preset sequence. The receiver can find, by performing preset sequence locking and preset sequence monitoring on the data sequence, preset sequences that periodically appear in the data sequence, and the receiver may delete, from the data sequence, padding sequences including the preset sequences. The receiver further determines a codeword in the data sequence based on the locked codeword boundary in the data sequence, and decodes the codeword in the data sequence. After locking the codeword boundary in the data sequence, the receiver further performs codeword boundary monitoring on the data sequence to determine whether the locked codeword boundary is unlocked. When the locked codeword boundary is unlocked, the receiver re-searches for a codeword boundary in the data sequence in the self-synchronization manner, and re-searches for a preset sequence in the data sequence based on the re-found codeword boundary. The rest can be deduced by analogy.

It can be learned from the descriptions of the foregoing self-synchronization solution that, in the self-synchronization solution, a codeword boundary in a data sequence can be found without using additional data inserted into the data sequence. Therefore, a process of searching for the codeword boundary is not affected by the additional data, and searching for the codeword boundary has high precision, short consumed time, high efficiency, and high reliability. However, if the receiver still searches for a preset sequence in a data sequence before decoding, bit errors in the data sequence before the decoding easily cause an increase in time consumed by the receiver in searching for the preset sequence, affecting a subsequent processing process of the receiver on the data sequence. For example, if the preset sequence is an FS, bit errors in the FS in the data sequence before the decoding easily cause the receiver to fail to find a real FS. This increases a probability of finding a non-real FS, and greatly reduces reliability of an FS found by the receiver. For another example, bit errors in an FS in the data sequence before the decoding easily cause the receiver to fail to verify an original correct FS position in an FS monitoring process. This increases time consumed by the receiver in finding a real FS, and reduces efficiency of searching for the FS in the data sequence.

Embodiments of this application provide a data processing method, an apparatus, and a communication system. The method, the apparatus, and the communication system are based on a same inventive concept. In the method, after a receiver obtains a data sequence including a plurality of FEC codewords, the receiver performs FEC decoding on at least one FEC codeword in the data sequence to obtain at least one decoded codeword, and the receiver finds a preset sequence in the at least one decoded codeword. For example, the preset sequence is an FS mentioned in discussion of the IEEE802.3dj standard, or the preset sequence is in an AM mentioned in the 200/400 GE standard defined in the IEEE802.3bs project. In a process of performing FEC decoding on the at least one FEC codeword in the data sequence, the receiver may perform error detection and error correction on the at least one FEC codeword. Most bit errors in the FEC decoding process are corrected, so that the at least one decoded codeword obtained through the FEC decoding has a low bit error ratio or may even have no bit error. This can reduce efficiency of searching for the preset sequence by the receiver due to impact of the bit errors, and searching for the preset sequence in the at least one decoded codeword by the receiver has short consumed time, and high efficiency, precision, and reliability, so that transmission efficiency and reliability of the communication system can be ensured. Because most bit errors are corrected in an FEC decoding process, mean time to lock (mean time to lock, MTTL) of the preset sequence (for example, an FS) can be greatly shortened, and mean time to false-unlock (mean time to false-unlock, MTTFU) of the preset sequence (for example, the FS) can be greatly prolonged. The MTTL is mean duration of a preset sequence locking process, and the MTTL is duration determined based on a locking probability. For example, p (p is a positive integer) preset sequence locking processes are performed on a data sequence, and duration of most of the p locking processes is first duration (for example, a quantity of locking processes whose duration is the first duration in the p locking processes is greater than a first quantity of times). In this case, MTTL of the data sequence is the first duration. The MTTFU is mean duration of preset sequence unlocking in a preset sequence monitoring process (to be specific, duration from a start of preset sequence monitoring to determining that the preset sequence is unlocked), and the MTTFU is duration determined based on a locking probability. For example, q (q is a positive integer) preset sequence monitoring processes are performed on a data sequence, and duration of preset sequence unlocking in most of the q monitoring processes is second duration (for example, a quantity of monitoring processes whose unlocking duration is the second duration in the q monitoring processes is greater than a second quantity of times). In this case, MTTFU of the data sequence is the second duration. In addition, compared with the codeword synchronization solution mentioned in the 200/400GE standard defined in the IEEE802.3bs project, in the technical solutions in embodiments of this application, time consumed by the receiver in searching for the preset sequence can be shortened without adding additional check logic (for example, an additional hardware circuit), and efficiency, precision, and reliability of searching for the preset sequence by the receiver are improved. An implementation process in embodiments of this application is simple and implementation costs are low.

In embodiments of this application, the receiver includes a host chip (host chip) and an optical module, and the optical module includes a chip. The method in embodiments of this application is performed by the host chip in the receiver, the optical module in the receiver, or the chip in the optical module in the receiver. The receiver obtains a data sequence including a plurality of FEC codewords, the receiver performs FEC decoding on at least one FEC codeword in the data sequence to obtain at least one decoded codeword, and the receiver searches for a preset sequence in the at least one decoded codeword. The receiver may be a forwarding device, a user terminal device, or a server device, and the receiver may include an Ethernet interface. The data sequence is obtained by the receiver based on an Ethernet signal received through an Ethernet interface of the receiver, and the Ethernet signal is sent by a transmitter to the receiver. The transmitter may be a forwarding device, a user terminal device, or a server device, and the transmitter may also include an Ethernet interface. The forwarding device may be a router or a switch. The Ethernet signal may be a Terabit Ethernet (Terabit Ethernet, TbE) signal. Terabit Ethernet is a high-speed Ethernet. Terabit Ethernet is an Ethernet whose speed exceeds 100 gigabits per second (100 Gbit/s). The speed of Terabit Ethernet can reach or exceed 200 Gbit/s or 400 Gbit/s. Therefore, Terabit Ethernet can implement high-speed data transmission.

The technical solutions in embodiments of this application may be applied to a concatenated FEC encoding scenario and a non-concatenated FEC encoding scenario. In a concatenated FEC encoding scenario, a transmitter performs at least two levels of FEC encoding on data that needs to be sent, and then sends encoded data to a receiver, and the receiver performs corresponding at least two levels of FEC decoding on the received data to obtain the original data. For example, the transmitter sequentially performs first FEC encoding and second FEC encoding on data that needs to be sent, and the receiver sequentially performs second FEC decoding and first FEC decoding on the received data. The second FEC decoding corresponds to the second FEC encoding, and the first FEC decoding corresponds to the first FEC encoding. Each of the first FEC encoding and the second FEC encoding is one-level (or referred to as one-layer) FEC encoding, and each of the first FEC decoding and the second FEC decoding is one-level FEC decoding. In some embodiments or technical documents, the first FEC encoding is also described as outer FEC encoding or outer encoding, the second FEC encoding is also described as inner FEC encoding or inner encoding, the second FEC decoding is also described as inner FEC decoding or inner decoding, and the first FEC decoding is also described as outer FEC decoding or outer decoding. In a non-concatenated FEC encoding scenario, a transmitter performs one-level (or referred to as one-layer) FEC encoding on data that needs to be sent, and sends data to a receiver, and the receiver performs one-level FEC decoding on the received data to obtain the original data. Non-concatenated FEC encoding is also referred to as single-level FEC encoding, single-layer FEC encoding, one-level FEC encoding, or one-layer FEC encoding. An FEC code used by the receiver to perform corresponding FEC decoding on the received data is the same as an FEC code used by the transmitter to perform FEC encoding on the data. For example, in a concatenated FEC encoding scenario, an FEC code used by the receiver to perform first FEC decoding on received data is the same as an FEC code used by the transmitter to perform first FEC encoding on the data, and an FEC code used by the receiver to perform second FEC decoding on the received data is the same as an FEC code used by the transmitter to perform second FEC encoding on the data. In embodiments of this application, the FEC code may be a Reed-Solomon code (Reed-Solomon code, RS code), a Bose-Chaudhuri-Hocquenghem code (Bose-Chaudhuri-Hocquenghem code, BCH code), an extended BCH code, a low-density parity-check code (low-density parity-check code, LDPC code), a Hamming code (Hamming code), an extended Hamming code, a Golay code (Golay code), a Reed-Muller code (Reed-Muller code), a staircase code (staircase code), a turbo code (turbo code), a turbo product code (turbo product code, TPC), or the like. For example, a transmitter first performs, by using an RS(544,514) code, first FEC encoding on data that needs to be sent, and then performs second FEC encoding on the data by using a Hamming(128,120) code or a Hamming(68,60) code. Then, the transmitter sends, to a receiver, a data sequence obtained through the first FEC encoding and the second FEC encoding. After the receiver receives the data sequence, the receiver first performs second FEC decoding on the data sequence by using the Hamming(128,120) code or the Hamming(68,60) code, and then performs first FEC decoding on the data sequence by using the RS(544,514) code. In embodiments of this application, when the transmitter inserts a preset sequence into the data, the receiver further needs to find the preset sequence in the received data sequence and delete a padding sequence including the preset sequence. Before deleting the padding sequence, the receiver may further extract information carried in the padding sequence for use by a physical layer. The padding sequence is the padding sequence in the IEEE802.3dj standard, and the preset sequence is the FS mentioned in the discussion of the IEEE802.3dj standard. Alternatively, the padding sequence is the AM in the 200/400GE standard defined in the IEEE802.3bs project, and the preset sequence is in the AM. For example, the preset sequence is an AM or a fixed part in the AM. This is not limited in embodiments of this application.

Application scenarios of the technical solutions provided in embodiments of this application are described below with reference to the accompanying drawings.

An application scenario in embodiments of this application includes a transmitter and a receiver. The transmitter is communicatively connected to the receiver. For example, the transmitter is connected to the receiver through an optical fiber. Specifically, each of the transmitter and the receiver may include an Ethernet interface, and the Ethernet interface of the transmitter is connected to the Ethernet interface of the receiver through the optical fiber. The transmitter includes a host chip (host chip) and/or an optical module, and the receiver includes a host chip and/or an optical module. For example, each of the transmitter and the receiver includes a host chip and an optical module. In the transmitter and/or the receiver, the host chip may be connected to the optical module through an interface like an AUI. For ease of description, the host chip in the transmitter is referred to as a host chip 1, the optical module in the transmitter is referred to as an optical module 1, the host chip in the receiver is referred to as a host chip 2, and the optical module in the receiver is referred to as an optical module 2.

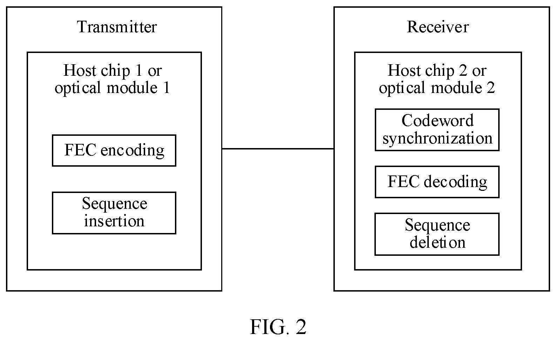

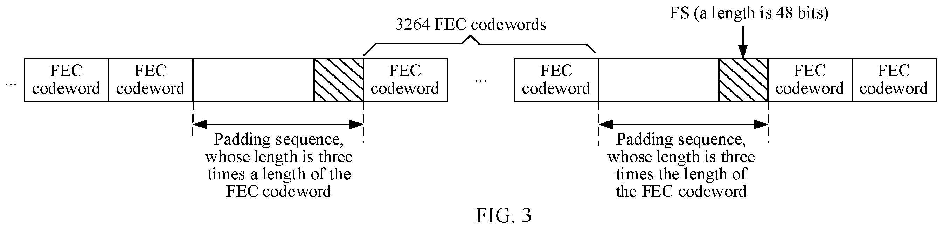

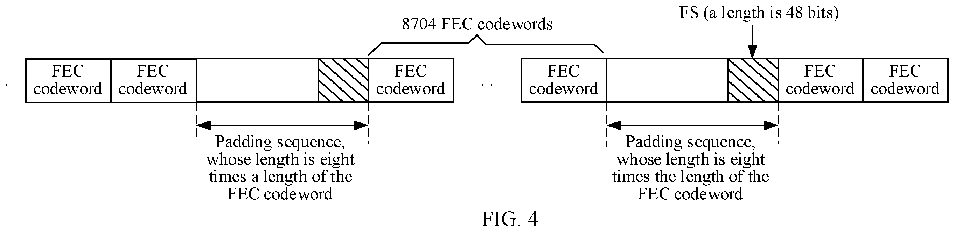

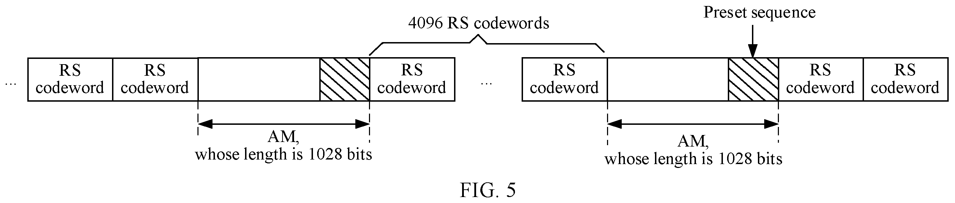

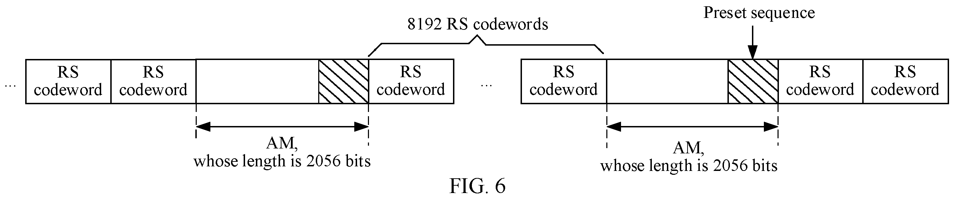

FIG. 2 is a diagram of an application scenario according to an embodiment of this application. The application scenario is a non-concatenated FEC encoding scenario. In the application scenario, a transmitter includes a host chip 1 and/or an optical module 1, and a receiver includes a host chip 2 and/or an optical module 2. When the transmitter sends a data sequence C0 to the receiver, the host chip 1 or the optical module 1 performs FEC encoding on the data sequence C0, and periodically inserts, into the data sequence C0, a padding sequence including a preset sequence to obtain a data sequence C1, where the data sequence C1 includes a plurality of FEC codewords obtained through the FEC encoding (the padding sequence also undergoes the FEC encoding, the padding sequence may include at least one FEC codeword obtained through the FEC encoding, and the FEC codeword in the padding sequence may be referred to as a padding codeword), and the transmitter sends the data sequence C1 to the receiver. For example, FIG. 3 is a diagram of a data sequence C1. In FIG. 3, an example in which a preset sequence is an FS is used for description. The data sequence C1 includes a plurality of FEC codewords and padding sequences that periodically appear, each padding sequence includes an FS, a length of the padding sequence is three times a length of the FEC codeword, a length of the FS is 48 bits, a periodicity at which the padding sequence appears in the data sequence C1 is 3264 FEC codewords (3264*128 bits), and a periodicity at which the FS appears in the data sequence C1 is 3264+3=3267 FEC codewords (3267*128 bits). For another example, FIG. 4 is a diagram of another data sequence C1. In FIG. 4, an example in which a preset sequence is an FS is used for description. The data sequence C1 includes a plurality of FEC codewords and padding sequences that periodically appear, each padding sequence includes an FS, a length of the padding sequence is eight times a length of the FEC codeword, a length of the FS is 48 bits, a periodicity at which the padding sequence appears in the data sequence C1 is 8704 FEC codewords (8704*128 bits), and a periodicity at which the FS appears in the data sequence C1 is 8704+8=8712 FEC codewords (8712*128 bits). For still another example, FIG. 5 is a diagram of still another data sequence C1. In FIG. 5, an example in which a padding sequence is an AM is used for description. The data sequence C1 includes a plurality of RS codewords and AMs that periodically appear, each AM includes a preset sequence, a length of the AM is 1028 bits, and a periodicity at which the AM appears in the data sequence C1 is 4096 RS codewords (4096*5440 bits). FIG. 6 is a diagram of yet another data sequence C1. In FIG. 6, an example in which a padding sequence is an AM is used for description. The data sequence C1 includes a plurality of RS codewords and AMs that periodically appear, each AM includes a preset sequence, a length of the AM is 2056 bits, and a periodicity at which the AM appears in the data sequence C1 is 8192 RS codewords (8192*5440 bits). The data sequence C1 shown in FIG. 5 and FIG. 6 is a data sequence obtained through RS encoding, and the RS encoding is also FEC encoding. Therefore, the RS codeword in the data sequence C1 shown in FIG. 5 and FIG. 6 is also an FEC codeword. After the receiver receives the data sequence C1, the host chip 2 or the optical module 2 performs codeword synchronization on the data sequence C1 (for example, performs codeword synchronization on the data sequence C1 in a self-synchronization manner) to determine an FEC codeword boundary in the data sequence C1, and the host chip 2 or the optical module 2 determines an FEC codeword in the data sequence C1 based on the FEC codeword boundary in the data sequence C1 (for the data sequence C1 shown in FIG. 5 and FIG. 6, the FEC codeword boundary is an RS codeword boundary, and the FEC codeword is an RS codeword). The host chip 2 or the optical module 2 performs FEC decoding on at least one FEC codeword in the data sequence C1 to obtain at least one decoded codeword. The host chip 2 or the optical module 2 searches for a preset sequence in the at least one decoded codeword, and the host chip 2 or the optical module 2 deletes, from the data sequence C1, a padding sequence including the preset sequence. The host chip 2 or the optical module 2 performs FEC decoding on all FEC codewords in the data sequence C1 and deletes the padding sequences from the data sequence C1, to obtain the data sequence C0.

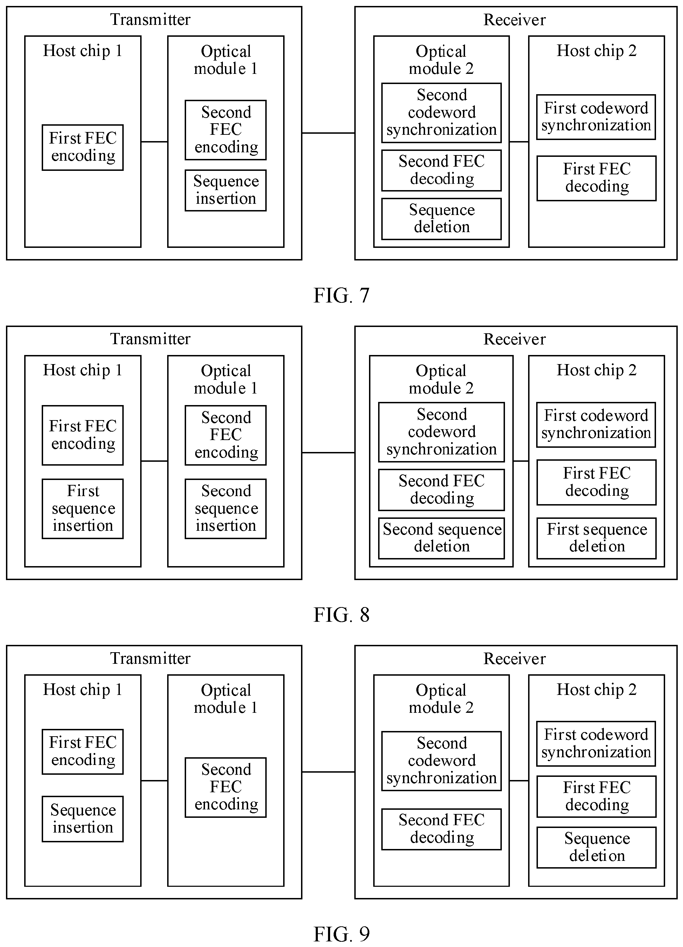

FIG. 7 is a diagram of another application scenario according to an embodiment of this application. The application scenario is a concatenated FEC encoding scenario. In the application scenario, a transmitter includes a host chip 1 and an optical module 1, and a receiver includes a host chip 2 and an optical module 2. When the transmitter sends a data sequence D0 to the receiver, the host chip 1 performs first FEC encoding on the data sequence D0 to obtain a data sequence D1, where the data sequence D1 includes a plurality of FEC codewords obtained through the first FEC encoding (for ease of description, the FEC codeword obtained through the first FEC encoding is referred to as an FEC codewords 1). The host chip 1 sends the data sequence D1 to the optical module 1, and the optical module 1 performs second FEC encoding on the data sequence D1 and periodically inserts a padding sequence including a preset sequence into the data sequence D1 to obtain a data sequence D2, where the data sequence D2 includes a plurality of FEC codewords obtained through the second FEC encoding (for ease of description, the FEC codeword obtained through the second FEC encoding is referred to as an FEC codeword 2, the padding sequence in the data sequence D2 also undergoes the second FEC encoding, and the padding sequence may include at least one FEC codeword 2 obtained through the second FEC encoding). For a distribution status of the FEC codeword and the padding sequence in the data sequence D2, refer to the data sequence C1 shown in FIG. 3 to FIG. 6. The transmitter sends the data sequence D2 to the receiver. After the receiver receives the data sequence D2, the optical module 2 performs second codeword synchronization on the data sequence D2 (for example, performs second codeword synchronization on the data sequence D2 in a self-synchronization manner) to determine an FEC codeword boundary in the data sequence D2, and the optical module 2 determines the plurality of FEC codewords 2 in the data sequence D2 based on the FEC codeword boundary in the data sequence D2. The optical module 2 performs second FEC decoding on at least one FEC codeword 2 in the data sequence D2 to obtain at least one decoded codeword, the optical module 2 searches for a preset sequence in the at least one decoded codeword, and the optical module 2 deletes, from the data sequence D2, a padding sequence including the found preset sequence. The optical module 2 performs second FEC decoding on all the FEC codewords 2 in the data sequence D2 and deletes the padding sequences from the data sequence D2, to obtain the data sequence D1. The optical module 2 sends the data sequence D1 to the host chip 2. The host chip 2 performs first codeword synchronization on the data sequence D1 (for example, performs first codeword synchronization in the self-synchronization manner) to determine an FEC codeword boundary in the data sequence D1, and the host chip 2 determines the plurality of FEC codewords 1 in the data sequence D1 based on the FEC codeword boundary in the data sequence D1. The host chip 2 performs first FEC decoding on the plurality of FEC codewords 1 to obtain a plurality of decoded codewords, where the plurality of decoded codewords form the data sequence D0.

FIG. 8 is a diagram of still another application scenario according to an embodiment of this application. The application scenario is a concatenated FEC encoding scenario. In the application scenario, a transmitter includes a host chip 1 and an optical module 1, and a receiver includes a host chip 2 and an optical module 2. When the transmitter sends a data sequence E0 to the receiver, the host chip 1 performs first FEC encoding on the data sequence E0, and periodically inserts a padding sequence including a preset sequence into the data sequence E0, to obtain a data sequence E1. The data sequence E1 includes a plurality of FEC codewords obtained through the first FEC encoding (for ease of description, the FEC codeword obtained through the first FEC encoding is referred to as an FEC codeword 1, the padding sequence inserted by the host chip 1 into the data sequence E0 is referred to as a padding sequence 1, the preset sequence included in the padding sequence 1 is referred to as a preset sequence 1, the padding sequence 1 also undergoes the first FEC encoding, and the padding sequence 1 may include at least one FEC codeword 1 obtained through the first FEC encoding). For a distribution status of the FEC codeword and the padding sequence in the data sequence E1, refer to the data sequence C1 shown in FIG. 3 to FIG. 6. The host chip 1 sends the data sequence E1 to the optical module 1. The optical module 1 performs second FEC encoding on the data sequence E1, and periodically inserts a padding sequence including a preset sequence into the data sequence E1, to obtain a data sequence E2. The data sequence E2 includes a plurality of FEC codewords obtained through the second FEC encoding (for ease of description, the FEC codeword obtained through the second FEC encoding is referred to as an FEC codeword 2, the padding sequence inserted by the optical module 1 into the data sequence E1 is referred to as a padding sequence 2, the preset sequence included in the padding sequence 2 is referred to as a preset sequence 2, the padding sequence 2 also undergoes the second FEC encoding, and the padding sequence 2 may include at least one FEC codeword 2 obtained through the second FEC encoding). For a distribution status of the FEC codeword and the padding sequence in the data sequence E2, refer to the data sequence C1 shown in FIG. 3 to FIG. 6. The transmitter sends the data sequence E2 to the receiver. After the receiver receives the data sequence E2, the optical module 2 performs second codeword synchronization on the data sequence E2 (for example, performs second codeword synchronization on the data sequence E2 in a self-synchronization manner) to determine an FEC codeword boundary in the data sequence E2, the optical module 2 determines the plurality of FEC codewords 2 in the data sequence E2 based on the FEC codeword boundary in the data sequence E2, the optical module 2 performs second FEC decoding on at least one FEC codeword 2 in the data sequence E2 to obtain at least one decoded codeword, and the optical module 2 searches for a preset sequence 2 in the at least one decoded codeword and deletes, from the data sequence E2, a padding sequence 2 including the preset sequence 2. The optical module 2 performs second FEC decoding on all the FEC codewords 2 in the data sequence E2 and deletes the padding sequences 2 from the data sequence E2, to obtain the data sequence E1. The optical module 2 sends the data sequence E1 to the host chip 2, the host chip 2 performs first codeword synchronization on the data sequence E1 (for example, performs first codeword synchronization on the data sequence E1 in the self-synchronization manner) to determine an FEC codeword boundary in the data sequence E1, the host chip 2 determines the plurality of FEC codewords 1 in the data sequence E1 based on the FEC codeword boundary in the data sequence E1, the host chip 2 performs first FEC decoding on at least one FEC codeword 1 in the data sequence E1 to obtain at least one decoded codeword, and the host chip 2 searches for a preset sequence 1 in the at least one decoded codeword and deletes, from the data sequence E1, a padding sequence 1 including the preset sequence 1. The host chip 2 performs first FEC decoding on all the FEC codewords 1 in the data sequence E1 and deletes the padding sequences 1 from the data sequence E1, to obtain the data sequence E0.

FIG. 9 is a diagram of yet another application scenario according to an embodiment of this application. The application scenario is a concatenated FEC encoding scenario. In the application scenario, a transmitter includes a host chip 1 and an optical module 1, and a receiver includes a host chip 2 and an optical module 2. When the transmitter sends a data sequence F0 to the receiver, the host chip 1 performs first FEC encoding on the data sequence F0, and periodically inserts a padding sequence including a preset sequence into the data sequence F0, to obtain a data sequence F1. The data sequence F1 includes a plurality of FEC codewords obtained through the first FEC encoding (for ease of description, the FEC codeword obtained through the first FEC encoding is referred to as an FEC codeword 1, the padding sequence in the data sequence F1 also undergoes the first FEC encoding, and the padding sequence may include at least one FEC codeword 1 obtained through the first FEC encoding). For a distribution status of the FEC codeword and the padding sequence in the data sequence F 1, refer to the data sequence C1 shown in FIG. 3 to FIG. 6. The host chip 1 sends the data sequence F1 to the optical module 1. The optical module 1 performs second FEC encoding on the data sequence F1 to obtain a data sequence F2. The data sequence F2 includes a plurality of FEC codewords obtained through the second FEC encoding (for ease of description, the FEC codeword obtained through the second FEC encoding is referred to as an FEC codeword 2). The transmitter sends the data sequence F2 to the receiver. After the receiver receives the data sequence F2, the optical module 2 performs second codeword synchronization on the data sequence F2 (for example, performs second codeword synchronization on the data sequence F2 in a self-synchronization manner) to determine an FEC codeword boundary in the data sequence F2, the optical module 2 determines the plurality of FEC codewords 2 in the data sequence F2 based on the FEC codeword boundary in the data sequence F2, and the optical module 2 performs second FEC decoding on the plurality of FEC codewords 2 to obtain a plurality of decoded codewords, where the plurality of decoded codewords form the data sequence F1. The optical module 2 sends the data sequence F1 to the host chip 2, the host chip 2 performs first codeword synchronization on the data sequence F1 (for example, performs first codeword synchronization on the data sequence F1 in the self-synchronization manner) to determine an FEC codeword boundary in the data sequence F1, the host chip 2 determines the plurality of FEC codewords 1 in the data sequence F1 based on the FEC codeword boundary in the data sequence F1, the host chip 2 performs first FEC decoding on at least one FEC codeword 1 in the data sequence F1 to obtain at least one decoded codeword, the host chip 2 searches for a preset sequence in the at least one decoded codeword, and the host chip 2 deletes, from the data sequence F1, a padding sequence including the preset sequence. The host chip 2 performs first FEC decoding on all the FEC codewords 1 in the data sequence F1 and deletes the padding sequences from the data sequence F1, to obtain the data sequence F0.

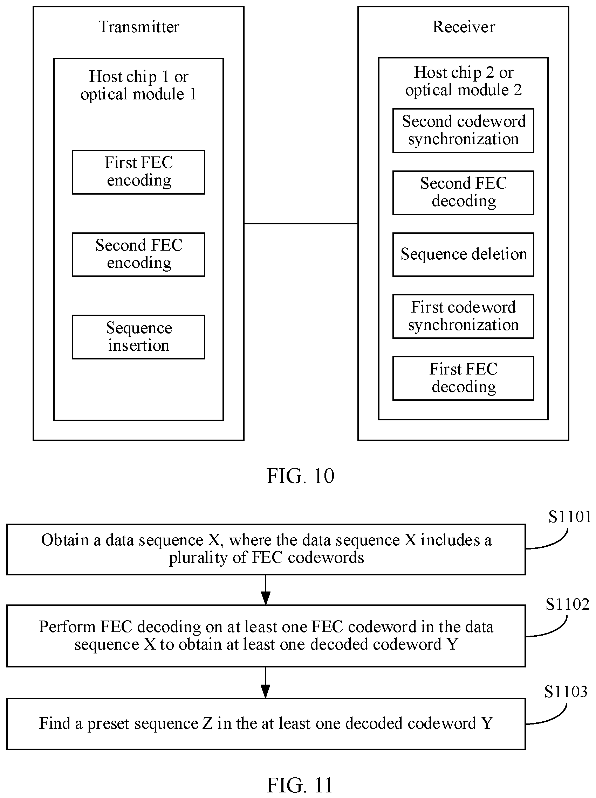

FIG. 10 is a diagram of yet another application scenario according to an embodiment of this application. The application scenario is a concatenated FEC encoding scenario. In the application scenario, a transmitter includes a host chip 1 and/or an optical module 1, and a receiver includes a host chip 2 and/or an optical module 2. When the transmitter sends a data sequence G0 to the receiver, the host chip 1 or the optical module 1 first performs first FEC encoding on the data sequence G0 to obtain a data sequence G1. The data sequence G1 includes a plurality of FEC codewords obtained through the first FEC encoding (for ease of description, the FEC codeword obtained through the first FEC encoding is referred to as an FEC codeword 1). Then, the host chip 1 or the optical module 1 performs second FEC encoding on the data sequence G1, and periodically inserts a padding sequence including a preset sequence into the data sequence G1, to obtain a data sequence G2. The data sequence G2 includes a plurality of FEC codewords obtained through the second FEC encoding (for ease of description, the FEC codeword obtained through the second FEC encoding is referred to as an FEC codeword 2, the padding sequence in the data sequence G2 also undergoes the second FEC encoding, and the padding sequence may include at least one FEC codeword 2 obtained through the second FEC encoding). For a distribution status of the FEC codeword and the padding sequence in the data sequence G2, refer to the data sequence C1 shown in FIG. 3 to FIG. 6. Finally, the transmitter sends the data sequence G2 to the receiver. After the receiver receives the data sequence G2, the host chip 2 or the optical module 2 performs second codeword synchronization on the data sequence G2 (for example, performs second codeword synchronization on the data sequence G2 in a self-synchronization manner) to determine an FEC codeword boundary in the data sequence G2, the host chip 2 or the optical module 2 determines the plurality of FEC codewords 2 in the data sequence G2 based on the FEC codeword boundary in the data sequence G2, the host chip 2 or the optical module 2 performs second FEC decoding on at least one FEC codeword 2 in the data sequence G2 to obtain at least one decoded codeword, and the host chip 2 or the optical module 2 searches for a preset sequence in the at least one decoded codeword and deletes, from the data sequence G2, a padding sequence including the preset sequence. The host chip 2 or the optical module 2 performs second FEC decoding on all the FEC codewords 2 in the data sequence G2 and deletes the padding sequences from the data sequence G2, to obtain the data sequence G1. The host chip 2 or the optical module 2 performs first codeword synchronization on the data sequence G1 (for example, performs first codeword synchronization in the self-synchronization manner) to determine an FEC codeword boundary in the data sequence G1, the host chip 2 or the optical module 2 determines the plurality of FEC codewords 1 in the data sequence G1 based on the FEC codeword boundary in the data sequence G1, and the host chip 2 or the optical module 2 performs first FEC decoding on the plurality of FEC codewords 1 to obtain a plurality of decoded codewords, where the plurality of decoded codewords form the data sequence G0.

It should be noted that the padding sequence in the descriptions of the application scenarios shown in FIG. 2 and FIG. 7 to FIG. 10 may be the padding sequence in the IEEE802.3dj standard, and the preset sequence may be the FS mentioned in the discussion of the IEEE802.3dj standard. Alternatively, the padding sequence is the AM in the 200/400GE standard defined in the IEEE802.3bs project, and the preset sequence is in the AM. For example, the preset sequence is an AM or a fixed part in the AM. In addition, the foregoing FEC encoding may be Reed-Solomon (Reed-Solomon, RS) encoding, Bose-Chaudhuri-Hocquenghem (Bose-Chaudhuri-Hocquenghem, BCH) encoding, low-density parity-check (low-density parity-check, LDPC) encoding, Hamming (Hamming) encoding, Golay (Golay) encoding, Reed-Muller (Reed-Muller) encoding, staircase (staircase) encoding, turbo (turbo) encoding, or turbo product code (turbo product code, TPC) encoding. Correspondingly, the foregoing FEC decoding may be Reed-Solomon (Reed-Solomon, RS) decoding, Bose-Chaudhuri-Hocquenghem (Bose-Chaudhuri-Hocquenghem, BCH) decoding, low-density parity-check (low-density parity-check, LDPC) decoding, Hamming (Hamming) decoding, Golay (Golay) decoding, Reed-Muller (Reed-Muller) decoding, staircase (staircase) decoding, turbo (turbo) decoding, or turbo product code (turbo product code, TPC) decoding. An FEC code used for FEC decoding is the same as an FEC code used for corresponding FEC encoding. For example, for the application scenarios shown in FIG. 7 to FIG. 10, an FEC code used for the first FEC encoding is the same as an FEC code used for the first FEC decoding, and an FEC code used for the second FEC encoding is the same as an FEC code used for the second FEC decoding. For example, the FEC code used for the first FEC encoding and the FEC code used for the first FEC decoding are both RS(544,514) codes, and the FEC code used for the second FEC encoding and the FEC code used for the second FEC decoding are both Hamming(128,120) codes or Hamming(68,60) codes. In the application scenario shown in FIG. 2, an FEC code used for the FEC encoding is the same as an FEC code used for the FEC decoding. For example, the FEC code used for the FEC encoding and the FEC code used for the FEC decoding are both RS(544,514) codes, Hamming(128,120) codes, or Hamming(68,60) codes.

In addition, for a data sequence on which the transmitter needs to perform FEC encoding and to which the transmitter needs to insert a padding sequence, an order in which the transmitter performs FEC encoding on the data sequence and inserts the padding sequence into the data sequence is not limited in embodiments of this application. For a data sequence on which the receiver needs to perform FEC decoding and from which the receiver needs to delete a padding sequence, an order in which the receiver performs FEC decoding on the data sequence and deletes the padding sequence from the data sequence is not limited in embodiments of this application. In addition, a process in which the receiver performs FEC decoding on the data sequence and a process in which the receiver deletes the padding sequence from the data sequence may be performed in an interleaved manner. For example, refer to FIG. 2 and related descriptions thereof. An order in which the host chip 1 or the optical module 1 performs FEC encoding on the data sequence C0 and inserts the padding sequence into the data sequence C0 is not limited in embodiments of this application. The host chip 1 or the optical module 1 may first perform FEC encoding on the data sequence C0, and then insert the padding sequence into the data sequence C0. Alternatively, the host chip 1 or the optical module 1 may first insert the padding sequence into the data sequence C0, and then perform FEC encoding on the data sequence C0. In an optional implementation, the host chip 1 or the optical module 1 first inserts the padding sequence into the data sequence C0, and then performs FEC encoding on the data sequence C0, so that the FEC encoding is also performed on the padding sequence. In an optional implementation, the host chip 1 or the optical module 1 first performs FEC encoding on the data sequence C0, and then inserts the padding sequence into the data sequence C0. The host chip 1 or the optical module 1 may further perform FEC encoding on the inserted padding sequence. Still refer to FIG. 2 and related descriptions thereof. An order in which the host chip 2 or the optical module 2 performs FEC decoding on the data sequence C1 and deletes, from the data sequence C1, the padding sequence including the preset sequence is not limited in embodiments of this application. The host chip 2 or the optical module 2 may first perform FEC decoding on all the FEC codewords in the data sequence C1, and then delete, from the data sequence C1, the padding sequences including the preset sequences. Alternatively, the host chip 2 or the optical module 2 may delete the padding sequences from the data sequence C1 while performing FEC decoding on the FEC codewords in the data sequence C1. For example, the host chip 2 or the optical module 2 first performs FEC decoding on a part of the FEC codewords in the data sequence C1, and then deletes a padding sequence from the part of the FEC codewords. Then, the host chip 2 or the optical module 2 first performs FEC decoding on another part of the FEC codewords in the data sequence C1, and deletes a padding sequence from the another part of the FEC codewords. The rest can be deduced by analogy.

The foregoing descriptions of the transmitter and the receiver are merely examples. In some embodiments, the transmitter is also referred to as a transmitter device, and the receiver is also referred to as a receiver device. Each of the transmitter and the receiver may be a forwarding device, a user terminal device, or a server device.

The foregoing describes the application scenarios of embodiments of this application, and the following describes method embodiments of this application.

FIG. 11 is a flowchart of a data processing method according to an embodiment of this application. The method is performed by a host chip in a receiver, an optical module in the receiver, or a chip in the optical module in the receiver. For ease of description, the following descriptions are provided by using an example in which the method is performed by the receiver. It may be understood that the method is specifically performed by the host chip in the receiver, the optical module in the receiver, or the chip in the optical module in the receiver. As shown in FIG. 11, the method includes step S1101 to step S1103.

S1101: Obtain a data sequence X, where the data sequence X includes a plurality of FEC codewords.

The data sequence X is obtained based on an Ethernet signal received through an Ethernet interface of the receiver, where the Ethernet interface may be a Terabit Ethernet interface, and the Ethernet signal may be a Terabit Ethernet signal.

In an embodiment, the receiver receives, through the Ethernet interface, an Ethernet signal sent by a transmitter, where the Ethernet signal carries the data sequence X, and the receiver extracts the data sequence X from the Ethernet signal. In another embodiment, the Ethernet signal carries an interleaved sequence of the data sequence X, the receiver extracts the interleaved sequence from the Ethernet signal, and the receiver de-interleaves the interleaved sequence to obtain the data sequence X.

The data sequence X is obtained by the transmitter by performing target FEC encoding on an initial data sequence, and the FEC codeword included in the data sequence X is an FEC codeword obtained by performing target FEC encoding. Lengths of the plurality of FEC codewords are equal, and a length of any one of the plurality of FEC codewords depends on an FEC code used by the transmitter to perform target FEC encoding. For example, the lengths of the plurality of FEC codewords are all 128 bits.

The data sequence X includes a preset sequence Z, the preset sequence Z periodically appears in the data sequence X, and the preset sequence Z is periodically inserted by the transmitter into the initial data sequence. For example, the data sequence X includes padding sequences that periodically appear, and each padding sequence includes the preset sequence Z. Optionally, the transmitter periodically inserts, into the initial data sequence, the padding sequence including the preset sequence Z. The padding sequence in this embodiment of this application may be the padding sequence in the IEEE802.3dj standard or the AM in the 200/400GE standard defined in the IEEE802.3bs project. The preset sequence Z may be the FS mentioned in the discussion of the IEEE802.3dj standard. Alternatively, the preset sequence Z is in the AM in the 200/400GE standard defined in the IEEE802.3bs project. That the preset sequence Z is in the AM may be understood as that the preset sequence Z is all or a part of the AM. For example, the preset sequence Z is the AM, or the preset sequence Z is a fixed part that is known to both the transmitter and the receiver and that is in the AM. The padding sequence in the data sequence X also undergoes the target FEC encoding. Optionally, the padding sequence is the padding sequence in the IEEE802.3dj standard, a length of the padding sequence is an integer multiple of the length of the FEC codeword in the data sequence X, and the padding sequence includes an integer quantity of FEC codewords. In this embodiment of this application, that the preset sequence Z periodically appears in the data sequence X may be that the preset sequence Z appears in the data sequence X based on a strict periodicity, in other words, a periodicity at which the preset sequence Z appears in the data sequence X is a strict periodicity, and different periodicities of the preset sequence Z are strictly equal. Alternatively, that the preset sequence Z periodically appears in the data sequence X may be that the preset sequence Z appears in the data sequence X based on a non-strict periodicity, in other words, a periodicity at which the preset sequence Z appears in the data sequence X is a non-strict periodicity, different non-strict periodicities of the preset sequence Z may not be equal, a difference between different non-strict periodicities is less than a preset difference, and a rule of appearance of the preset sequence Z is approximately periodic. This is not limited in this embodiment of this application.

The initial data sequence is a data sequence before the transmitter performs target FEC encoding, in other words, the initial data sequence is an object on which the transmitter performs target FEC encoding. The transmitter may first insert, into the initial data sequence, a padding sequence including the preset sequence Z, and then perform target FEC encoding on the initial data sequence; or may first perform target FEC encoding on the initial data sequence, and then insert, into the initial data sequence, a padding sequence including the preset sequence Z. An order in which the transmitter performs target FEC encoding on the initial data sequence and inserts the padding sequence into the initial data sequence is not limited in this embodiment of this application. If the transmitter first inserts the padding sequence into the initial data sequence, the transmitter may perform target FEC encoding on the padding sequence in a process of performing target FEC encoding on the initial data sequence. If the transmitter first performs target FEC encoding on the initial data sequence, after inserting the padding sequence into the initial data sequence, the transmitter may further perform target FEC encoding on the inserted padding sequence. In this embodiment of this application, the initial data sequence may not undergo FEC encoding, or may undergo other FEC encoding. A padding sequence may be inserted into the initial data sequence, or no padding sequence may be inserted into the initial data sequence. For example, in a non-concatenated FEC encoding scenario, the initial data sequence may not undergo FEC encoding. In a concatenated FEC encoding scenario, the initial data sequence may undergo other FEC encoding, or a padding sequence may be inserted into the initial data sequence. In an example, refer to FIG. 2 and related descriptions thereof. FIG. 2 shows a non-concatenated FEC encoding scenario. The initial data sequence is a data sequence C0, the data sequence X is a data sequence C1, and the initial data sequence may not undergo FEC encoding and no padding sequence is inserted into the initial data sequence. In another example, refer to FIG. 7 and related descriptions thereof. FIG. 7 shows a concatenated FEC encoding scenario. The initial data sequence is a data sequence D1, the data sequence X is a data sequence D2, the initial data sequence undergoes first FEC encoding and no padding sequence is inserted into the initial data sequence, and the target FEC encoding is second FEC encoding. In still another example, refer to FIG. 8 and related descriptions thereof. FIG. 8 shows a concatenated FEC encoding scenario. The initial data sequence is a data sequence E0, the data sequence X is a data sequence E1, the initial data sequence does not undergo FEC encoding and no padding sequence is inserted into the initial data sequence, and the target FEC encoding is first FEC encoding; or the initial data sequence is a data sequence E1, the data sequence X is a data sequence E2, the initial data sequence undergoes first FEC encoding and a padding sequence 1 is inserted into the initial data sequence, and the target FEC encoding is second FEC encoding. In yet another example, refer to FIG. 9 and related descriptions thereof. FIG. 9 shows a concatenated FEC encoding scenario. The initial data sequence is a data sequence F0, the data sequence X is a data sequence F1, the initial data sequence does not undergo FEC encoding and no padding sequence is inserted into the initial data sequence, and the target FEC encoding is first FEC encoding. In yet another example, refer to FIG. 10 and related descriptions thereof. FIG. 10 shows a concatenated FEC encoding scenario. The initial data sequence is a data sequence G1, the data sequence X is a data sequence G2, the initial data sequence undergoes first FEC encoding and no padding sequence is inserted into the initial data sequence, and the target FEC encoding is second FEC encoding.

S1102: Perform FEC decoding on at least one FEC codeword in the data sequence X to obtain at least one decoded codeword Y.

The performing FEC decoding on the FEC codeword in the data sequence X in this step and the following descriptions refers to performing target FEC decoding on the FEC codeword in the data sequence X. The target FEC decoding is FEC decoding corresponding to the target FEC encoding in S1101, and an FEC code used for the target FEC decoding is the same as an FEC code used for the target FEC encoding.

The at least one FEC codeword in the data sequence X may be all the FEC codewords in the data sequence X, or may be a part of the FEC codewords in the data sequence X. The at least one decoded codeword Y corresponds one-to-one to the at least one FEC codeword. The at least one decoded codeword Y may be a decoded codeword obtained by performing target FEC decoding on all the FEC codewords in the data sequence X, or may be a decoded codeword obtained by performing target FEC decoding on a part of the FEC codewords in the data sequence X. This is not limited in this embodiment of this application.

In this specification, only the target FEC decoding performed by the receiver on the FEC codeword in the data sequence X is described, and a detailed decoding process is not described. For an implementation process in which the receiver performs target FEC decoding on any FEC codeword in the data sequence X, refer to an FEC decoding-related technical document.

S1103: Find the preset sequence Z in the at least one decoded codeword Y.

The receiver searches for the preset sequence Z in the at least one decoded codeword Y based on the preset sequence Z known to the receiver, and the receiver may find the preset sequence Z in the at least one decoded codeword Y. Optionally, the receiver compares (for example, compares bit by bit), with the at least one decoded codeword Y, the preset sequence Z known to the receiver, to search for the preset sequence Z in the at least one decoded codeword Y.

In an embodiment, the preset sequence Z includes a plurality of nibbles (nibble), where a length of each nibble is 4 bits. In a process in which the receiver compares, with any codeword Y in the at least one decoded codeword Y, the preset sequence Z known to the receiver, if a quantity of nibbles that are in the any codeword Y and that match the plurality of nibbles in the preset sequence Z reaches a specified quantity, the receiver determines that the any codeword Y matches the preset sequence Z, and the receiver determines that the preset sequence Z is found in the any codeword Y. In an example, a length of the preset sequence Z is 48 bits, the preset sequence Z includes 12 nibbles, and the specified quantity is 9. In other words, if a quantity of nibbles that are in any codeword Y and that match the plurality of nibbles in the preset sequence Z reaches 9, it is considered that the any codeword Y matches the preset sequence Z, and the receiver determines that the preset sequence Z is found in the any codeword Y.

The at least one decoded codeword Y may be a decoded codeword obtained by the receiver by performing target FEC decoding on all the FEC codewords in the data sequence X, or may be a decoded codeword obtained by the receiver by performing target FEC decoding on a part of the FEC codewords in the data sequence X. Therefore, with reference to S1102 and S1103, it can be learned that the receiver may first perform target FEC decoding on all the FEC codewords in the data sequence X, and then search for the preset sequence Z in all decoded codewords Y; or may search for the preset sequence Z in the decoded codeword Y while performing target FEC decoding on the FEC codeword in the data sequence X. For example, the receiver first performs target FEC decoding on a part of the FEC codewords in the data sequence X, and searches for the preset sequence Z in codewords obtained by decoding the part of the FEC codewords; and then the receiver performs target FEC decoding on another part of the FEC codewords in the data sequence X, and searches for the preset sequence Z in codewords obtained by decoding the another part of the FEC codewords. The rest can be deduced by analogy. Optionally, the receiver groups the FEC codewords in the data sequence X to obtain a plurality of codeword groups, where each group of the plurality of codeword groups includes at least one FEC codeword in the data sequence X, FEC codewords in any two groups of the plurality of codeword groups do not overlap, the receiver performs target FEC decoding on the FEC codewords in the data sequence X group by group, the receiver may obtain one group of decoded codewords each time after decoding the FEC codeword in one codeword group, and the receiver searches for the preset sequence Z in the group of decoded codewords. This is not limited in this embodiment of this application.

The following describes implementation processes of S1102 and S1103 in two embodiments.

First embodiment: The receiver performs target FEC decoding on all the FEC codewords in the data sequence X, and the receiver searches for the preset sequence Z in all the decoded codewords Y. Optionally, the receiver performs FEC decoding (namely, target FEC decoding) on the plurality of FEC codewords (namely, all the FEC codewords) in the data sequence X to obtain a plurality of decoded codewords Y, where the plurality of decoded codewords Y may correspond one-to-one to the plurality of FEC codewords; and the receiver searches for the preset sequence Z in the plurality of decoded codewords Y, and the receiver may find the preset sequence Z in the plurality of decoded codewords Y. For example, the receiver may find a plurality of preset sequences Z in the plurality of decoded codewords Y.

In a specific embodiment, an arrangement order of the plurality of decoded codewords Y is the same as an arrangement order of the plurality of FEC codewords. The receiver sequentially searches for the preset sequence Z in the plurality of decoded codewords Y in the arrangement order of the plurality of decoded codewords Y, until a 1^{st} preset sequence Z is found. For example, the plurality of decoded codewords Y are a codeword Y1, a codeword Y2, a codeword Y3, ..., and the codeword Y1, the codeword Y2, the codeword Y3... are sequentially arranged. The receiver first searches for the preset sequence Z in the codeword Y1. If the receiver finds the preset sequence Z in the codeword Y1, the receiver finds a 1^{st} preset sequence Z. If the receiver does not find the preset sequence Z in the codeword Y1, the receiver continues to search for the preset sequence Z in the codeword Y2. If the receiver finds the preset sequence Z in the codeword Y2, the receiver finds a 1^{st} preset sequence Z. If the receiver does not find the preset sequence Z in the codeword Y2, the receiver continues to search for the preset sequence Z in the codeword Y3. The rest can be deduced by analogy, until a 1^{st} preset sequence Z is found. After the receiver finds the 1^{st} preset sequence Z in the plurality of decoded codewords Y, for example, the receiver finds the 1^{st} preset sequence Z in the codeword Y1, the receiver determines, based on a periodicity at which the preset sequence Z appears in the data sequence X (for ease of description, the periodicity at which the preset sequence Z appears in the data sequence X is referred to as a target periodicity), at least one codeword in codewords that are in the plurality of decoded codewords Y and that are after the codeword Y1. An interval between adjacent codewords in the at least one codeword is the target periodicity, and an interval between a 1^{st} codeword in the at least one codeword and the codeword Y1 is the target periodicity. The receiver searches for the preset sequence Z in the at least one codeword until the at least one codeword is searched. In other words, the receiver searches for the 1^{st} preset sequence Z in the plurality of decoded codewords Y codeword by codeword, and after finding the 1^{st} preset sequence Z in the plurality of decoded codewords Y, the receiver does not search for the preset sequence Z codeword by codeword, but searches for the preset sequence Z in the plurality of decoded codewords Y based on the target periodicity. Therefore, efficiency of searching for the preset sequence Z can be improved.

Optionally, after the receiver finds the 1^{st} preset sequence Z in the plurality of decoded codewords Y, the receiver searches for the preset sequence Z in the plurality of decoded codewords Y based on the target periodicity. If a quantity of preset sequences Z continuously found by the receiver in the plurality of decoded codewords Y reaches a specified quantity (for example, the specified quantity is 3, and an interval between the 1^{st} preset sequence Z and a preset sequence Z that is in the specified quantity of preset sequences Z and that is adjacent to the 1^{st} preset sequence Z is the target periodicity, or the specified quantity of preset sequences Z includes the 1^{st} preset sequence Z), the receiver locks the 1^{st} found preset sequence Z. A process of the receiver from starting to search for the 1^{st} preset sequence Z to locking the 1^{st} found preset sequence Z may be referred to as a preset sequence locking process. After the receiver locks the 1^{st} preset sequence Z, the receiver performs a preset sequence monitoring process. Specifically, the receiver continues to search for the preset sequence Z in the plurality of decoded codewords Y based on the target periodicity and a target preset sequence found in the preset sequence locking process (for example, the target preset sequence is a last preset sequence found in the preset sequence locking process), until codewords Y distributed in the plurality of decoded codewords Y based on the target periodicity are searched, or until the locked preset sequence is unlocked (the preset sequence monitoring process fails). For example, the preset sequence is the FS mentioned in the discussion of the IEEE802.3dj standard, the preset sequence locking process may be referred to as an FS locking process, and the preset sequence monitoring process may be referred to as an FS monitoring process. For another example, if the preset sequence is in the AM mentioned in the 200/400 GE standard, the preset sequence locking process may be referred to as an AM locking process, and the preset sequence monitoring process may be referred to as an AM monitoring process. Because the receiver performs preset sequence locking and preset sequence monitoring based on the decoded codeword of the data sequence X, and a bit error ratio of the decoded codeword is low, a probability of preset sequence false-unlocking can be reduced. The preset sequence false-unlocking means that a preset sequence is correctly locked but a preset sequence monitoring process fails. For example, in the preset sequence monitoring process, if the preset sequence Z is not found in a plurality of continuous target periodicities, or if a proportion of a periodicity in which the data sequence X is not found in the plurality of continuous target periodicities reaches a preset proportion, it is considered that the preset sequence monitoring process fails.

Second embodiment: The receiver searches for the preset sequence Z in the decoded codeword Y while performing target FEC decoding on the FEC codeword in the data sequence X. In an implementation, the receiver performs FEC decoding (namely, target FEC decoding) on a first FEC codeword in the data sequence X to obtain a decoded first codeword, and the receiver searches for the preset sequence Z in the decoded first codeword. If the decoded first codeword does not include the preset sequence Z, in other words, the receiver does not find the preset sequence Z in the decoded first codeword, the receiver continues to perform FEC decoding (namely, target FEC decoding) on an FEC codeword that is in the data sequence X and that is after the first FEC codeword, and searches for the preset sequence Z in decoded codewords until a 1^{st} preset sequence Z is found. If the decoded first codeword includes the preset sequence Z, in other words, the receiver finds the preset sequence Z in the decoded first codeword, the receiver performs FEC decoding (namely, target FEC decoding) on a second FEC codeword that is in the data sequence X and that is after the first FEC codeword to obtain a decoded second codeword, and the receiver attempts to search for the preset sequence Z in the decoded second codeword. The first FEC codeword is an FEC codeword in the data sequence X. For example, the first FEC codeword is a 1^{st} FEC codeword in the data sequence X, and an interval between the second FEC codeword and the first FEC codeword is a periodicity at which the preset sequence Z appears in the data sequence X.

In a specific embodiment, if the receiver finds the preset sequence Z in the decoded first codeword, the receiver determines the second FEC codeword that is in the data sequence X and that is after the first FEC codeword, where an interval between the second FEC codeword and the first FEC codeword is a target periodicity (namely, a periodicity at which the preset sequence Z appears in the data sequence X), the receiver performs target FEC decoding on the second FEC codeword to obtain a decoded second codeword, and the receiver attempts to search for the preset sequence Z in the decoded second codeword. In addition, the receiver determines a third FEC codeword that is in the data sequence X and that is after the second FEC codeword, where an interval between the third FEC codeword and the second FEC codeword is the target periodicity. The receiver performs target FEC decoding on the third FEC codeword to obtain a decoded third codeword, and the receiver attempts to search for the preset sequence Z in the decoded third codeword. In addition, the receiver determines a fourth FEC codeword that is in the data sequence X and that is after the third FEC codeword, where an interval between the fourth FEC codeword and the third FEC codeword is the target periodicity. The receiver performs target FEC decoding on the fourth FEC codeword to obtain a decoded fourth codeword, and the receiver attempts to search for the preset sequence Z in the decoded fourth codeword. The rest can be deduced by analogy. In other words, if the receiver finds the preset sequence Z in the decoded first codeword, the receiver traverses, based on the target periodicity, FEC codewords that are in the data sequence X and that are after the first FEC codeword (an interval between two adjacent FEC codewords traversed based on the target periodicity is the target periodicity), and the receiver performs target FEC decoding on the traversed FEC codewords, and attempts to search for the preset sequence Z in decoded codewords. In other words, if the receiver finds the preset sequence Z in the decoded first codeword, the receiver attempts to search, based on the target periodicity, for the preset sequence Z in the FEC codewords that are in the data sequence X and that are after the first FEC codeword. Optionally, the preset sequence Z found by the receiver in the decoded first codeword is a 1^{st} preset sequence Z found by the receiver. After the receiver finds the 1^{st} preset sequence Z, the receiver traverses, based on the target periodicity, the FEC codewords that are in the data sequence X and that are after the first FEC codeword. The receiver performs target FEC decoding on the traversed FEC codewords, and attempts to search for the preset sequence Z in the decoded codewords. If a quantity of preset sequences Z continuously found by the receiver in the data sequence X reaches a specified quantity (for example, the specified quantity is 3, and an interval between the 1^{st} preset sequence Z and a preset sequence Z that is in the specified quantity of preset sequences Z and that is adjacent to the 1^{st} preset sequence Z is the target periodicity, or the specified quantity of preset sequences Z includes the 1^{st} preset sequence Z), the receiver locks the 1^{st} found preset sequence Z. A process of the receiver from starting to search for the 1^{st} preset sequence Z to locking the 1^{st} found preset sequence Z may be referred to as a preset sequence locking process. After the receiver locks the 1^{st} preset sequence Z, the receiver performs a preset sequence monitoring process. Specifically, the receiver continues to traverse the FEC codewords of the data sequence X based on the target periodicity and a position of a target preset sequence, in the data sequence X, found in the preset sequence locking process (for example, the target preset sequence is a last preset sequence found in the preset sequence locking process). The receiver performs target FEC decoding on the traversed FEC codewords, and searches for the preset sequence Z in the decoded codewords until FEC codewords distributed in the data sequence X based on the target periodicity are searched, or until the locked preset sequence is unlocked (the preset sequence monitoring process fails). Because the receiver performs preset sequence locking and preset sequence monitoring on the data sequence X based on the decoded codeword of the data sequence X, and a bit error ratio of the decoded codeword is low, a probability of preset sequence false-unlocking can be reduced.

In a specific embodiment, if the receiver does not find the preset sequence Z in the decoded first codeword, the receiver sequentially performs, in an arrangement order of the FEC codewords in the data sequence X, target FEC decoding on a plurality of FEC codewords that are in the data sequence X and that are after the first FEC codeword, and sequentially searches for the preset sequence Z in decoded codewords. Specifically, each time the receiver obtains a decoded codeword, the receiver searches for the preset sequence Z in the decoded codeword. If the preset sequence Z is not found in the decoded codeword, the receiver performs target FEC decoding on a next FEC codeword, and searches for the preset sequence Z in a next decoded codeword. The rest can be deduced by analogy, until a 1^{st} preset sequence Z is found. Any two adjacent FEC codewords in the plurality of FEC codewords after the first FEC codeword have adjacent codeword boundaries, and a codeword boundary of an FEC codeword that is in the plurality of FEC codewords and that is adjacent to the first FEC codeword is adjacent to a codeword boundary of the first FEC codeword. That the two FEC codewords have adjacent codeword boundaries herein means that: In the two FEC codewords, an end of a former FEC codeword (for example, a last bit in the former FEC codeword) is adjacent to a start of a latter FEC codeword (for example, a 1^{st} bit in the latter FEC codeword), there is no other bit between the end of the former FEC codeword and the start of the latter FEC codeword, and a next bit of the last bit in the former FEC codeword is the 1^{st} bit in the latter FEC codeword. Optionally, after the receiver finds the 1^{st} preset sequence Z, for example, the receiver finds the 1^{st} preset sequence Z in a decoded codeword of a target FEC codeword in the data sequence X, the receiver traverses, based on the target periodicity (namely, the periodicity at which the preset sequence Z appears in the data sequence X), FEC codewords that are in the data sequence X and that are after the target FEC codeword, the receiver performs target FEC decoding on the traversed FEC codewords, and searches for the preset sequence Z in decoded codewords. In other words, before finding the 1^{st} preset sequence Z, the receiver sequentially searches for the preset sequence Z in the arrangement order of the FEC codewords in the data sequence X (in other words, searches for the preset sequence Z FEC codeword by FEC codeword) in the data sequence X. After finding the 1^{st} preset sequence Z, the receiver does not search for the preset sequence Z FEC codeword by FEC codeword, but searches for the preset sequence Z in the data sequence X based on the target periodicity. Therefore, efficiency of searching for the preset sequence Z can be improved.

Optionally, after the receiver finds the 1^{st} preset sequence Z in the data sequence X, the receiver searches for the preset sequence Z in the data sequence X based on the target periodicity. If a quantity of preset sequences Z continuously found by the receiver in a plurality of FEC codewords reaches a specified quantity (for example, the specified quantity is 3, and an interval between the 1^{st} preset sequence Z and a preset sequence Z that is in the specified quantity of preset sequences Z and that is adjacent to the 1^{st} preset sequence Z is the target periodicity, or the specified quantity of preset sequences Z includes the 1^{st} preset sequence Z), the receiver locks the 1^{st} found preset sequence Z. A process of the receiver from starting to search for the 1^{st} preset sequence Z to locking the 1^{st} found preset sequence Z may be referred to as a preset sequence locking process. After the receiver locks the 1^{st} preset sequence Z, the receiver performs a preset sequence monitoring process. Specifically, the receiver continues to search for the preset sequence Z in the data sequence X based on the target periodicity and a position of a target preset sequence, in the data sequence X, found in the preset sequence locking process (for example, the target preset sequence is a last preset sequence found in the preset sequence locking process), until FEC codewords distributed in the data sequence X based on the target periodicity are searched, or until the locked preset sequence is unlocked (the preset sequence monitoring process fails). Because the receiver performs preset sequence locking and preset sequence monitoring on the data sequence X based on the decoded codeword of the data sequence X, and a bit error ratio of the decoded codeword is low, a probability of preset sequence false-unlocking can be reduced.

In an optional embodiment, the receiver performs FEC decoding (namely, target FEC decoding) on the first FEC codeword in the data sequence X in a first decoding manner, and the receiver performs, in a second decoding manner, FEC decoding (namely, target FEC decoding) on a candidate FEC codeword that is in the data sequence X and that is after the first FEC codeword. The receiver may also perform FEC decoding (namely, target FEC decoding) on the second FEC codeword in the data sequence X in the first decoding manner. One of the first decoding manner and the second decoding manner is soft-decision decoding (soft-decision decoding, SDD), and the other is hard-decision decoding (hard-decision decoding, HDD). In other words, the first decoding manner is SDD, and the second decoding manner is HDD; or the first decoding manner is HDD, and the second decoding manner is SDD. The candidate FEC codeword described herein may include all FEC codewords that are not decoded in the data sequence X after the receiver locks the preset sequence. In an embodiment, the receiver performs target FEC decoding on the FEC codeword in the data sequence X in the first decoding manner in a preset sequence locking process, and the receiver performs target FEC decoding on the FEC codeword in the data sequence X in the second decoding manner after the preset sequence is locked. The receiver performs formal data processing on the data sequence X after the preset sequence is locked, and the formal data processing includes performing target FEC decoding on the FEC codeword in the data sequence X. In an example, the first decoding manner is HDD, and the second decoding manner is SDD. Because decoding complexity of HDD is lower, and decoding performance of SDD is better (for example, there are fewer bit errors in the decoded codeword), the receiver performs target FEC decoding on the FEC codeword in the data sequence X in the first decoding manner (namely, HDD) in the preset sequence locking process, so that complexity of locking the preset sequence by the receiver can be reduced. After the preset sequence is locked, the receiver performs target FEC decoding on the FEC codeword in the data sequence X in the second decoding manner (namely, SDD), so that bit error performance of the formal data processing of the receiver can be ensured. In another example, the first decoding manner is SDD, and the second decoding manner is HDD. The receiver performs target FEC decoding on the FEC codeword in the data sequence X in the first decoding manner (namely, SDD) in the preset sequence locking process, so that reliability of locking the preset sequence by the receiver can be improved. After the preset sequence is locked, the receiver performs target FEC decoding on the FEC codeword in the data sequence X in the second decoding manner (namely, HDD), so that complexity of the formal data processing of the receiver can be reduced. In this embodiment of this application, the first decoding manner and the second decoding manner are implemented by using same hardware logic, in other words, SDD and HDD are implemented by using same hardware logic. For example, SDD is implemented by using a specific hardware circuit, and HDD is implemented by using a part of the specific hardware circuit. Therefore, implementation complexity and implementation costs in the technical solutions of this application can be reduced.

In conclusion, according to the technical solution provided in this embodiment of this application, after the receiver obtains a data sequence including a plurality of FEC codewords, the receiver performs FEC decoding on at least one FEC codeword in the data sequence to obtain at least one decoded codeword, and the receiver finds a preset sequence in the at least one decoded codeword. Because the receiver may perform error detection and error correction on the at least one FEC codeword in a process of performing FEC decoding on the at least one FEC codeword, the at least one decoded codeword has a low bit error ratio or may even have no bit error. This can reduce efficiency of searching for the preset sequence by the receiver due to impact of the bit errors, and searching for the preset sequence by the receiver in the at least one decoded codeword has short consumed time, and high efficiency, precision, and reliability, so that transmission efficiency and reliability of a communication system are ensured. Especially when a bit error ratio of a data sequence obtained by the receiver is high, a large benefit can be gained in the technical solution in this embodiment of this application. In addition, an FEC decoding process performed by the receiver on the data sequence in a preset sequence locking process and an FEC decoding process performed by the receiver on the data sequence in a formal data processing process are implemented by using same hardware logic, and time consumed by the receiver in searching for the preset sequence can be shortened without adding additional check logic. This improves efficiency, precision, and reliability of searching for the preset sequence by the receiver. An implementation process in this embodiment of this application is simple, implementation costs are low, and an application scope is wide.

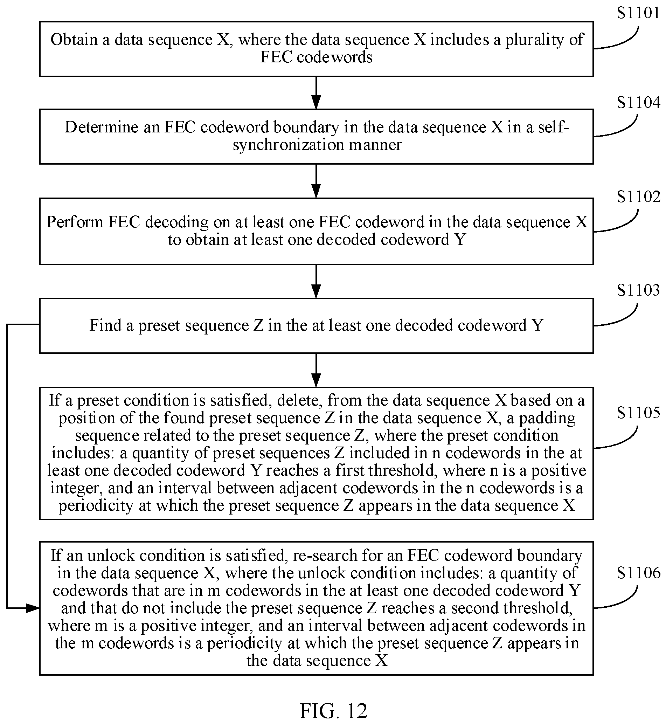

In an optional embodiment, FIG. 12 is a flowchart of another data processing method according to an embodiment of this application. Before S1102, the data processing method further includes the following step S1104.

S1104: Determine an FEC codeword boundary in the data sequence X in a self-synchronization manner.

For a manner of determining the FEC codeword boundary in the data sequence X in the self-synchronization manner, refer to the patent application document "CODEWORD SYNCHRONIZATION METHOD, RECEIVER, NETWORK DEVICE, AND NETWORK SYSTEM" with the publication number CN113517949A, and refer to the standard document "INNER CODEWORD SELF-SYNC PROPOSAL" (address: https://www.ieee802.org/3/dj/public/23_07/he_3dj_03b_2307.pdf). Both of which are incorporated herein by reference in their entireties as if they were all stated. Details are not described herein again.

After the receiver determines the FEC codeword boundary in the data sequence X, the receiver locks the FEC codeword boundary in the data sequence X. In addition, after the receiver determines the FEC codeword boundary in the data sequence X (for example, after the receiver locks the FEC codeword boundary in the data sequence X), the receiver determines, based on the FEC codeword boundary in the data sequence X, the plurality of FEC codewords included in the data sequence X, and further performs FEC decoding on at least one of the plurality of FEC codewords, and searches for the preset sequence Z in a decoded codeword, that is, performs S1102 and S1103.

In an optional embodiment, refer to FIG. 12. After S1103, the data processing method further includes the following step S1105.

S1105: If a preset condition is satisfied, delete, from the data sequence X based on a position of the found preset sequence Z in the data sequence X, a padding sequence related to the preset sequence Z, where the preset condition includes: a quantity of preset sequences Z included in n codewords in the at least one decoded codeword Y reaches a first threshold, where n is a positive integer, and an interval between adjacent codewords in the n codewords is a periodicity at which the preset sequence Z appears in the data sequence X.

That the quantity of preset sequences Z included in the n codewords reaches the first threshold may be that the quantity of preset sequences Z included in the n codewords is greater than the first threshold, or may be that the quantity of preset sequences Z included in the n codewords is greater than or equal to the first threshold. The interval between the adjacent codewords in the n codewords is the periodicity at which the preset sequence Z appears in the data sequence X, and the n codewords are continuous, in other words, the n codewords are continuous based on the periodicity at which the preset sequence Z appears in the data sequence X. All or a part of the n codewords include the preset sequence Z. One codeword usually includes one preset sequence Z, and some codewords may not include the preset sequence Z. Both a value of n and the first threshold may be set based on an actual situation. For example, n=3, and the first threshold is 3.

A padding sequence that is in the data sequence X and that is related to the preset sequence Z is a padding sequence that is in the data sequence X and that includes the preset sequence Z. For example, if a padding sequence includes the preset sequence Z, the padding sequence is related to the preset sequence Z, and the padding sequence is a padding sequence related to the preset sequence Z. In an embodiment, the preset sequence Z is the FS mentioned in the discussion of the IEEE802.3dj standard, and the padding sequence related to the preset sequence Z is the padding sequence including the FS in the IEEE802.3dj standard. In another embodiment, the preset sequence Z is in the AM defined in the 200/400GE standard defined in the IEEE802.3bs project, and the padding sequence related to the preset sequence Z is the AM.

In a process in which the receiver searches for the preset sequence Z in the at least one decoded codeword Y, for example, in a preset sequence locking process, the receiver monitors whether the preset condition is satisfied. For example, the receiver detects in real time or periodically whether the preset condition is satisfied. If the receiver determines that the preset condition is satisfied, the receiver obtains the preset sequence Z that has been found by the receiver in the at least one decoded codeword Y when the preset condition is satisfied. For each preset sequence Z that has been found by the receiver in the at least one decoded codeword Y when the preset condition is satisfied, the receiver determines, based on a position of the preset sequence Z in the data sequence X, a padding sequence that is in the data sequence X and that is related to the preset sequence Z, and the receiver deletes, from the data sequence X, the padding sequence that is related to the preset sequence Z. Optionally, the receiver monitors, in the preset sequence locking process, whether the preset condition is satisfied. If the receiver determines that the preset condition is satisfied, the receiver locks a 1^{st} found preset sequence Z, and then the receiver performs a preset sequence detection process. Specifically, the receiver continues to search for the preset sequence Z in the at least one decoded codeword Y based on a position of a target preset sequence, in the data sequence X, found in the preset sequence locking process (for example, the target preset sequence is a last preset sequence found in the preset sequence locking process), and deletes, from the data sequence X based on the position of the found preset sequence Z in the data sequence X, a padding sequence related to the preset sequence Z, until FEC codewords distributed in the data sequence X based on a target periodicity are searched, or until the locked preset sequence is unlocked (the preset sequence monitoring process fails). The preset condition includes: the quantity of preset sequences Z included in the n codewords in the at least one decoded codeword Y reaches the first threshold, and the interval between the adjacent codewords in the n codewords is a periodicity (namely, the target periodicity described above) in which the preset sequence Z appears in the data sequence X. That the quantity of preset sequences Z included in the n codewords reaches the first threshold indicates that the quantity of preset sequences Z included in the n codewords is large, and further indicates that the preset sequence that has been found by the receiver has no problem (for example, the found preset sequence is a real preset sequence). Therefore, when the quantity of preset sequences Z included in the n codewords reaches the first threshold, the receiver deletes, from the data sequence X based on the position of the found preset sequence Z in the data sequence X, the padding sequence that is related to the preset sequence Z.

In an embodiment, the receiver performs target FEC decoding on the plurality of FEC codewords (namely, all the FEC codewords) in the data sequence X to obtain a plurality of decoded codewords Y, and the receiver searches for the preset sequence Z in the plurality of decoded codewords Y. The receiver monitors, in a process of searching for the preset sequence Z in the plurality of decoded codewords Y, whether the preset condition is satisfied. If the receiver determines that the preset condition is satisfied, the receiver locks a 1^{st} found preset sequence Z, and then the receiver continues to search, based on the target periodicity and a target preset sequence found in a preset sequence locking process (for example, the target preset sequence is a last preset sequence found in the preset sequence locking process), for the preset sequence Z in a codeword that is after a codeword that has been searched for in the plurality of decoded codewords Y currently, and deletes, from the data sequence X based on a position of the found preset sequence Z in the data sequence X, a padding sequence related to the preset sequence Z.

In another embodiment, the receiver searches for the preset sequence Z in the decoded codeword Y while performing target FEC decoding on the FEC codeword in the data sequence X. The receiver monitors, in a process of searching for the preset sequence Z in the data sequence X, whether the preset condition is satisfied. If the receiver determines that the preset condition is satisfied, the receiver locks a 1^{st} found preset sequence Z, and then the receiver continues to search, based on the target periodicity and a target preset sequence found in a preset sequence locking process (for example, the target preset sequence is a last preset sequence found in the preset sequence locking process), for the preset sequence Z in an FEC codeword that is after an FEC codeword that has been searched for in the data sequence X currently, and deletes, from the data sequence X based on a position of the found preset sequence Z in the data sequence X, a padding sequence related to the preset sequence Z. Optionally, after the receiver determines that the preset condition is satisfied, the receiver traverses, based on the target periodicity, FEC codewords that are in the data sequence X and that are after a currently decoded FEC codeword, and the receiver performs target FEC decoding on the traversed FEC codewords, and searches for the preset sequence Z in decoded codewords until FEC codewords that are after the currently decoded FEC codeword and that are distributed based on the target periodicity are traversed.

In an optional embodiment, still refer to FIG. 12. After S1103, the data processing method further includes the following step S1106.

S1106: If an unlock condition is satisfied, re-search for an FEC codeword boundary in the data sequence X, where the unlock condition includes: a quantity of codewords that are in m codewords in the at least one decoded codeword Y and that do not include the preset sequence Z reaches a second threshold, where m is a positive integer, and an interval between adjacent codewords in the m codewords is a periodicity at which the preset sequence Z appears in the data sequence X.

That the quantity of codewords that are in the m codewords and that do not include the preset sequence Z reaches the second threshold may be that the quantity of codewords that are in the m codewords and that do not include the preset sequence Z is greater than the second threshold, or may be that the quantity of codewords that are in the m codewords and that do not include the preset sequence Z is greater than or equal to the second threshold. The interval between the adjacent codewords in the m codewords is the periodicity at which the preset sequence Z appears in the data sequence X. Optionally, the m codewords are continuous, in other words, the m codewords are continuous based on the periodicity at which the preset sequence Z appears in the data sequence X. All or a part of the m codewords include the preset sequence Z. One codeword usually includes one preset sequence Z, and some codewords may not include the preset sequence Z. Both a value of m and the second threshold are set based on an actual situation. For example, m=12, and the second threshold is 12. The unlock condition described herein may also be described as "a quantity of codewords that are in the m codewords in the at least one decoded codeword Y and that include erroneous (bad) preset sequences Z reaches the second threshold", and the erroneous (bad) preset sequence is also referred to as a terrible preset sequence, an incorrect preset sequence, an invalid preset sequence, or the like.

In this embodiment of this application, after the receiver locks the FEC codeword boundary in the data sequence X, the receiver determines, based on the FEC codeword boundary in the data sequence X, the plurality of FEC codewords included in the data sequence X, and further performs FEC decoding on at least one of the plurality of FEC codewords to obtain the at least one decoded codeword Y. In a process in which the receiver searches for the preset sequence Z in the at least one decoded codeword Y, for example, in a preset sequence monitoring process, the receiver monitors whether the unlock condition is satisfied. For example, the receiver detects in real time or periodically whether the unlock condition is satisfied. If the receiver determines that the unlock condition is satisfied, the receiver determines that the locked FEC codeword boundary is incorrect, and the locked FEC codeword boundary is unlocked (or referred to as that the data sequence X is unlocked). The receiver re-searches for an FEC codeword boundary in the data sequence X. For example, the receiver re-searches for the FEC codeword boundary in the data sequence X in the self-synchronization manner (or referred to as re-determining the FEC codeword boundary in the data sequence X). The receiver re-determines, based on the re-found FEC codeword boundary, a plurality of FEC codewords included in the data sequence X, and further performs FEC decoding on at least one of the re-determined plurality of FEC codewords and searches for the preset sequence Z. For example, the receiver performs S1102, S1103, and S1105 based on the re-found FEC codeword boundary. Optionally, if the receiver determines that the unlock condition is not satisfied, the receiver determines that a locked FEC codeword is not unlocked (or referred to as that the data sequence X is not unlocked), and the receiver continues to search for the preset sequence Z in the original at least one decoded codeword Y, and continues to monitor whether the unlock condition is satisfied, until the unlock condition is satisfied or the at least one decoded codeword Y is searched. The unlock condition includes: the quantity of codewords that are in the m codewords in the at least one decoded codeword Y and that do not include the preset sequence Z reaches the second threshold, and the interval between the adjacent codewords in the m codewords is the target periodicity. That the quantity of codewords that are in the m codewords and that do not include the preset sequence Z reaches the second threshold indicates that a quantity of preset sequences Z included in the m codewords is small, and further indicates that the FEC codeword boundary locked by the receiver is incorrect. Therefore, when the quantity of codewords that are in the m codewords and that include the preset sequence Z reaches the second threshold, the receiver re-searches for an FEC codeword boundary in the data sequence X.

In an embodiment, in S1102, the receiver performs target FEC decoding on the plurality of FEC codewords (namely, all the FEC codewords) in the data sequence X to obtain a plurality of decoded codewords Y, and in S1103, the receiver searches for the preset sequence Z in the plurality of decoded codewords Y. If the unlock condition is not satisfied, the receiver continues to search, based on the target periodicity, for the preset sequence in a codeword that is in the plurality of decoded codewords Y and that is after a codeword that has been searched for currently, and continues to monitor whether the unlock condition is satisfied, until the unlock condition is satisfied or the plurality of decoded codewords Y are searched based on the target periodicity. For example, the receiver continues to traverse, based on the target periodicity, the codeword that is in the plurality of decoded codewords Y and that is after the codeword that has been searched for currently, and an interval between two adjacent codewords traversed by the receiver based on the target periodicity is the target periodicity.

In another embodiment, in S1102 and S1103, the receiver searches for the preset sequence Z in the decoded codeword Y while performing target FEC decoding on the FEC codeword in the data sequence X. If the unlock condition is not satisfied, the receiver continues to search, based on the target periodicity, for the preset sequence Z in an FEC codeword that is in the data sequence X and that is after an FEC codeword that has been searched for currently, and continues to monitor whether the unlock condition is satisfied, until the unlock condition is satisfied or the FEC codewords in the data sequence X are searched based on the target periodicity. Optionally, if the unlock condition is not satisfied, the receiver traverses, based on the target periodicity, FEC codewords that are in the data sequence X and that are after a currently decoded FEC codeword, performs target FEC decoding on the traversed FEC codewords, and searches for the preset sequence Z in decoded codewords.

In this embodiment of this application, an example in which the unlock condition includes: the quantity of codewords that are in the m codewords in the at least one decoded codeword Y and that do not include the preset sequence Z reaches the second threshold is used for description. In other words, a quantity of preset sequences Z found by the receiver in the decoded codeword Y is used as a determining condition of whether the FEC codeword boundary is unlocked. The unlock condition may further include another condition. In an optional embodiment, after locking the FEC codeword boundary in the data sequence X, the receiver further performs codeword boundary monitoring on the data sequence X to determine whether the unlocking condition is satisfied. In this embodiment, the unlocking condition may include: a quantity of uncorrectable codewords that continuously appear in the data sequence X reaches a preset quantity, a proportion of uncorrectable codewords that continuously appear in the data sequence X reaches a preset ratio, or the like. In these cases, the receiver considers that the locked FEC codeword boundary is incorrect, and the receiver re-searches for an FEC codeword boundary in the data sequence X. The preset quantity and the preset ratio may be set based on an actual situation. The uncorrectable codewords that continuously appear are uncorrectable codewords that continuously appear in a plurality of FEC codewords on which the receiver continuously perform target FEC decoding. The plurality of FEC codewords may be continuous or discontinuous (for example, an interval between some FEC codewords in the plurality of FEC codewords may be the target periodicity). Optionally, the data sequence X includes an FEC codeword X1, an FEC codeword X2, an FEC codeword X3, ..., and an FEC codeword Xh. The receiver continuously performs target FEC decoding on the FEC codeword X1, the FEC codeword X4, and the FEC codeword X7. In this case, the FEC codeword X1, the FEC codeword X4, and the FEC codeword X7 are a plurality of FEC codewords on which the receiver continuously perform target FEC decoding. The uncorrectable codewords that continuously appear are uncorrectable codewords that continuously appear in the FEC codeword X1, the FEC codeword X4, and the FEC codeword X7. For example, if the receiver determines, through the target FEC decoding, that both the FEC codeword X1 and the FEC codeword X4 are uncorrectable codewords, the FEC codeword X1 and the FEC codeword X4 are "uncorrectable codewords that continuously appear" described in this embodiment of this application. The proportion of the uncorrectable codewords that continuously appear in the data sequence X is a proportion of the uncorrectable codewords that continuously appear in the plurality of FEC codewords on which the receiver continuously perform target FEC decoding, and is specifically a ratio of a quantity of the uncorrectable codewords that continuously appear in the plurality of FEC codewords to a quantity of the plurality of FEC codewords. For example, if the receiver continuously performs target FEC decoding on the FEC codeword X1, the FEC codeword X4, and the FEC codeword X7, and determines that both the FEC codeword X1 and the FEC codeword X4 are uncorrectable codewords, the receiver determines that the proportion of the uncorrectable codewords that continuously appear is 0.5. In a specific embodiment, in a process in which the receiver performs codeword boundary monitoring on the data sequence X, the receiver performs target FEC decoding on the FEC codeword in the data sequence X based on a locked FEC codeword boundary, and the receiver determines, based on a decoding result, whether the FEC codeword is an uncorrectable codeword to perform uncorrectable codeword monitoring. If the receiver determines, in the monitoring process, that a quantity of uncorrectable codewords that continuously appear reaches a preset quantity or a proportion of uncorrectable codewords that continuously appear reaches a preset ratio, the receiver determines that the unlock condition is satisfied, the locked FEC codeword boundary is unlocked, and an FEC codeword boundary in the data sequence X is re-searched for. It can be learned that there may be a plurality of unlock conditions in this embodiment of this application. A plurality of unlock conditions are set to monitor whether the locked FEC codeword boundary is unlocked, so that reliability of unlock monitoring performed by the receiver can be improved.

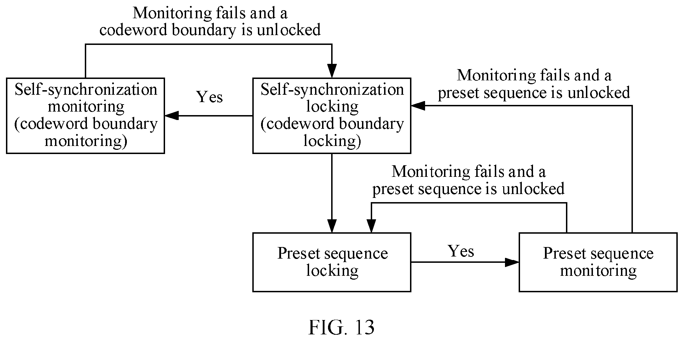

As described above, in this embodiment of this application, the receiver determines the FEC codeword boundary in the data sequence X in the self-synchronization manner, and after the receiver determines the FEC codeword boundary in the data sequence X, the receiver locks the FEC codeword boundary in the data sequence X. After locking the FEC codeword boundary in the data sequence X, the receiver further performs FEC codeword boundary monitoring on the data sequence X, to determine whether the locked FEC codeword boundary is unlocked. Because the receiver determines the FEC codeword boundary in the data sequence X in the self-synchronization manner and locks the FEC codeword boundary in the data sequence X, a process in which the receiver locks the FEC codeword boundary (a process of the receiver from starting to search for the FEC codeword boundary in the data sequence X to locking the FEC codeword boundary in the data sequence X by the receiver) may be referred to as a self-synchronization locking process or a codeword boundary locking process, and a process in which the receiver performs FEC codeword boundary monitoring on the data sequence X may be referred to as a self-synchronization monitoring process or a codeword boundary monitoring process. In an optional embodiment, FIG. 13 is a diagram of a data processing method according to an embodiment of this application. As shown in FIG. 13, a receiver first performs a self-synchronization locking process to perform FEC codeword boundary locking on a data sequence X, and then performs a self-synchronization monitoring process based on a locked FEC codeword boundary to perform FEC codeword boundary monitoring on the data sequence X. Specifically, the receiver performs target FEC decoding on an FEC codeword in the data sequence X based on the locked FEC codeword boundary, and the receiver performs uncorrectable codeword monitoring on the data sequence X based on a decoding result. In a self-synchronization monitoring process performed by the receiver, if the receiver determines that self-synchronization monitoring fails (for example, a quantity of uncorrectable codewords that continuously appear in the data sequence X reaches a preset quantity, or a proportion of uncorrectable codewords that continuously appear in the data sequence X reaches a preset ratio), the receiver determines that the locked FEC codeword boundary is unlocked, the receiver re-performs a self-synchronization locking process to perform FEC codeword boundary locking on the data sequence X, and the receiver performs a self-synchronization monitoring process based on a re-locked FEC codeword boundary. In this way, a closed-loop procedure of self-synchronization locking-self-synchronization monitoring-self-synchronization locking is formed.

As shown in FIG. 13, after locking the FEC codeword boundary in the data sequence X, the receiver further performs a preset sequence locking process based on the locked FEC codeword boundary to lock a preset sequence Z in the data sequence X, and the receiver performs a preset sequence monitoring process based on the locked preset sequence Z. Specifically, the receiver performs target FEC decoding on at least one FEC codeword in the data sequence X based on the locked FEC codeword boundary to obtain at least one decoded codeword Y, and the receiver searches for the preset sequence Z in the at least one decoded codeword Y. If a quantity of preset sequences Z continuously found by the receiver in the at least one decoded codeword Y reaches a first threshold (for example, 3), for example, if the receiver determines that the preset condition in S1105 is satisfied, the receiver locks a 1^{st} found preset sequence Z. Specifically, in the preset sequence monitoring process, the receiver searches for the preset sequence Z in the at least one decoded codeword Y based on a target periodicity and a position of a target preset sequence, in the data sequence X, found in the preset sequence locking process (for example, the target preset sequence is a last preset sequence found in the preset sequence locking process), until it is determined that a quantity of codewords that are in m codewords in the at least one decoded codeword Y and that do not include the preset sequence Z reaches a second threshold (in other words, until the unlock condition in S1106 is satisfied), the receiver determines that the preset sequence monitoring process fails, or until the receiver searches the at least one decoded codeword Y based on the target periodicity. If the receiver determines that preset sequence monitoring fails, the receiver determines that the locked preset sequence is unlocked. Because the locked preset sequence is locked based on the locked FEC codeword boundary, when the locked preset sequence is unlocked, it may be considered that the locked FEC codeword boundary is unlocked. Therefore, as shown in FIG. 13, if the receiver determines that the preset sequence monitoring fails, the receiver re-performs a self-synchronization locking process to perform FEC codeword boundary locking on the data sequence X, the receiver performs a self-synchronization monitoring process based on a re-locked FEC codeword boundary, and the receiver performs target decoding on an FEC codeword in the data sequence X based on the re-locked FEC codeword boundary, performs a preset sequence locking process, and performs a preset sequence monitoring process based on a re-locked preset sequence Z. In this way, a closed-loop procedure of self-synchronization locking-preset sequence locking-preset sequence monitoring-self-synchronization locking is formed. Optionally, if the receiver determines that the preset sequence monitoring fails, the receiver may alternatively skip the self-synchronization locking process and directly re-perform a preset sequence locking process. In this way, a closed-loop procedure of preset sequence locking-preset sequence monitoring-preset sequence locking is formed. This is not limited in this embodiment of this application.

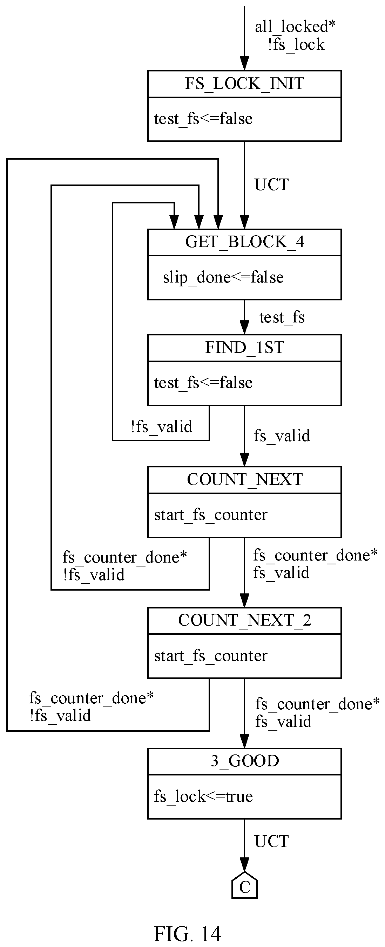

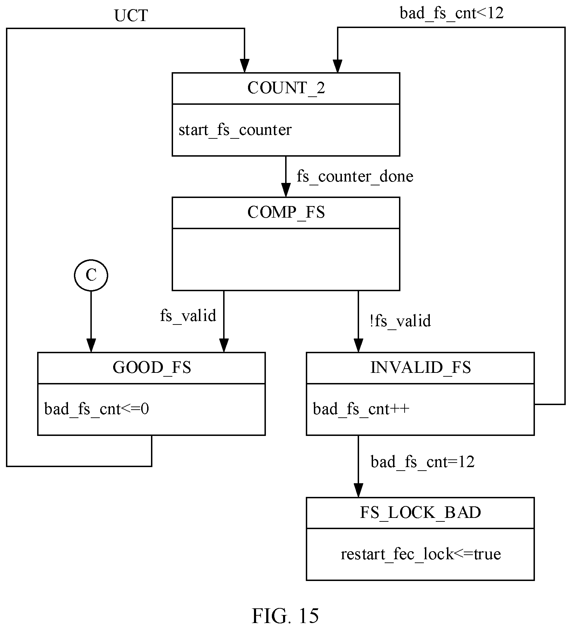

The following uses an example in which the preset sequence Z is an FS to describe the preset sequence locking process and the preset sequence monitoring process. As shown in FIG. 14 and FIG. 15, FIG. 14 is a state diagram of a preset sequence locking process according to an embodiment of this application, and FIG. 15 is a state diagram of a preset sequence monitoring process according to an embodiment of this application. FIG. 14 is described by using an example in which the receiver locks an FS in the data sequence X when a quantity of FSs found by the receiver in the at least one decoded codeword Y reaches the first threshold, in other words, the receiver locks the FS in the data sequence X when the preset condition in S1105 is satisfied. In addition, FIG. 14 is described by using an example in which the first threshold is 3. FIG. 15 is described by using an example in which the unlock condition is: a quantity of codewords that are in the m codewords in the at least one decoded codeword of the data sequence X and that do not include FSs reaches the second threshold, and FIG. 15 is described by using an example in which the second threshold is 12. For example, the unlock condition is: a quantity of erroneous (bad) FSs included in the m codewords in the at least one decoded codeword of the data sequence X reaches 12. In FIG. 14 and FIG. 15, a large rectangular box formed by superimposing two small rectangular boxes represents a state of a state machine. In each large rectangular box, a state name is recorded in an upper small rectangular box, and an operation performed by the state machine in a corresponding state is recorded in a lower small rectangular box. For example, in FIG. 14, "FS_LOCK_INIT" is the state name, and "test_fs<=false" in the small rectangular box below the small rectangular box in which "FS _LOCK_INIT" is located indicates that an operation performed by the state machine in the "FS _LOCKINIT" state is assigning a value "false" to a variable "test_fs". In an arrow connected to each large rectangular box indicating the state, content recorded in an arrow whose end is connected to the large rectangular box is a conversion condition for the state machine to enter the state indicated by the large rectangular box, and content recorded in an arrow whose head is connected to the large rectangular box is a conversion condition for the state machine to exit the state indicated by the large rectangular box. For example, in FIG. 14, a conversion condition for the state machine to enter the state "FS_LOCK_INIT" is all_locked* and !fs_lock, and a conversion condition for the state machine to exit the state "FS_LOCK_INIT" is UCT. UCT is unconditional transition (unconditional transition), in other words, the state machine can exit the state "FS_LOCK_INIT" without any condition. The rest can be deduced by analogy. It can be learned from FIG. 14 that, in an FS locking process, the receiver continuously searches for an FS; and when a quantity of FSs found continuously reaches 3, the receiver locks the FSs. It can be learned from FIG. 15 that, after locking the FS, the receiver enters an FS monitoring process. In the FS monitoring process, when a quantity of erroneous (bad) FSs found continuously reaches 12, the receiver determines that the FSs are unlocked, so that the receiver re-searches for an FEC codeword boundary in the data sequence X.

The data processing method provided in embodiments of this application may be performed by all hardware, or may be performed by software and hardware in cooperation. For example, the step of performing FEC decoding on the FEC codeword in the data sequence X and the step before the decoding may be performed by hardware, and the step after decoding the FEC codeword in the data sequence X may be performed by software. Optionally, the receiver includes an obtaining module, a synchronization module, a decoding module, a searching module, and a deletion module. The obtaining module, the synchronization module, and the decoding module are all hardware modules, and the searching module and the deletion module are both software modules. For example, the obtaining module is also referred to as an obtaining circuit, the synchronization module is also referred to as a synchronization circuit, and the decoding module is also referred to as a decoding circuit (or referred to as an FEC decoding circuit, an FEC decoder, or the like). The obtaining module extracts a data sequence X from an Ethernet signal received by the receiver, the synchronization module searches for an FEC codeword boundary in the data sequence X, the decoding module performs FEC decoding on an FEC codeword in the data sequence X, the searching module finds a preset sequence Y in a decoded codeword, and the deletion module monitors whether a preset condition is satisfied, and deletes, from the data sequence X when the preset condition is satisfied, a padding sequence related to the preset sequence Z. In an optional embodiment, the decoding module may send all decoded codewords to the searching module, and the searching module searches for the preset sequence in all the decoded codewords. Alternatively, the decoding module may send a part of decoded codewords to the searching module, and the searching module searches for the preset sequence in the part of the decoded codewords. For example, the decoding module screens a decoding result, and the decoding module sends a part of selected codewords to the searching module. Optionally, the decoding module screens the decoding result based on a target periodicity (namely, a periodicity at which the preset sequence Z appears in the data sequence X), and sends a part of selected codewords to the searching module. This is not limited in this embodiment of this application.

In this embodiment of this application, both a length and content of the preset sequence are fixed. In some technical documents, the preset sequence is also referred to as a fixed sequence or uses a similar name.

The foregoing embodiments are described by using an example in which this application is applied to the Ethernet. An application scenario of embodiments of this application is not limited to the Ethernet. Embodiments of this application may be further applied to network systems such as an optical transport network (optical transport network, OTN), a secret private network (secret private network, SPN), a fiber channel (fiber channel), and an infiniband (infiniband).

The foregoing describes the method embodiments of this application, and the following describes apparatus embodiments of this application. The apparatus in this application may be configured to perform the method in this application. For details that are not disclosed in the apparatus embodiments of this application, refer to the method embodiments.

An embodiment of this application provides a data processing apparatus. The apparatus is configured to perform the method embodiment shown in FIG. 10 or FIG. 11.

Optionally, the apparatus includes an Ethernet interface. The Ethernet interface may be a Terabit Ethernet interface.

Optionally, the apparatus is any one of the following: a forwarding device, a user terminal device, a server device, a host chip, an optical module, or a chip in the optical module. The forwarding device may be a router or a switch.

In an implementation, the apparatus includes at least one module, and the at least one module is configured to perform the method shown in FIG. 10 or FIG. 11. The at least one module may be implemented based on software, hardware, or a combination of software and hardware, and the at least one module may be randomly combined or divided based on a specific implementation.

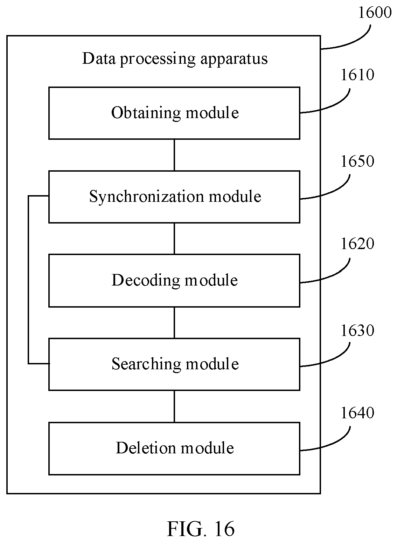

Optionally, FIG. 16 is a diagram of a data processing apparatus 1600 according to an embodiment of this application. The apparatus 1600 includes an obtaining module 1610, a decoding module 1620, and a searching module 1630.

The obtaining module 1610 is configured to obtain a data sequence, where the data sequence includes a plurality of FEC codewords. The decoding module 1620 is configured to perform FEC decoding on at least one FEC codeword in the data sequence to obtain at least one decoded codeword. The searching module 1630 is configured to find a preset sequence in the at least one decoded codeword. For a function implementation of the obtaining module 1610, refer to related descriptions in S1101. For a function implementation of the decoding module 1620, refer to related descriptions in S1102. For a function implementation of the searching module 1630, refer to related descriptions in S1103.

Optionally, the preset sequence is a sequence that periodically appears in the data sequence.

Optionally, still refer to FIG. 16. The apparatus 1600 further includes a deletion module 1640, configured to: if a preset condition is satisfied, delete, from the data sequence based on a position of the found preset sequence in the data sequence, a padding sequence related to the preset sequence, where the preset condition includes: a quantity of preset sequences included in n codewords in the at least one decoded codeword reaches a first threshold, where n is a positive integer, and an interval between adjacent codewords in the n codewords is a periodicity at which the preset sequence appears in the data sequence. For a function implementation of the deletion module 1640, refer to the descriptions in S1105.

Optionally, still refer to FIG. 16. The apparatus 1600 further includes a synchronization module 1650, configured to: if an unlock condition is satisfied, re-search for an FEC codeword boundary in the data sequence, where the unlock condition includes: a quantity of codewords that are in m codewords in the at least one decoded codeword and that do not include the preset sequence reaches a second threshold, where m is a positive integer, and an interval between adjacent codewords in the m codewords is a periodicity at which the preset sequence appears in the data sequence. For a function implementation of the synchronization module 1650, refer to the descriptions in S1106.

Optionally, the decoding module 1620 is configured to perform FEC decoding on the plurality of FEC codewords to obtain a plurality of decoded codewords; and correspondingly, the searching module 1630 is configured to find the preset sequence in the plurality of decoded codewords.

Optionally, the decoding module 1620 is configured to: perform FEC decoding on a first FEC codeword in the data sequence to obtain a decoded first codeword; and if the decoded first codeword does not include the preset sequence, continue to perform FEC decoding on an FEC codeword that is in the data sequence and that is after the first FEC codeword, until a 1^{st} preset sequence is found.

Optionally, the decoding module 1620 is further configured to: if the decoded first codeword includes the preset sequence, perform FEC decoding on a second FEC codeword that is in the data sequence and that is after the first FEC codeword to obtain a decoded second codeword, where an interval between the second FEC codeword and the first FEC codeword is a periodicity at which the preset sequence appears in the data sequence; and
the searching module 1630 is further configured to attempt to search for the preset sequence in the decoded second codeword.

Optionally, the decoding module 1620 is configured to: perform FEC decoding on the first FEC codeword in the data sequence in a first decoding manner; and perform, in a second decoding manner, FEC decoding on a candidate FEC codeword that is in the data sequence and that is after the first FEC codeword.

Optionally, the first decoding manner is soft-decision decoding, and the second decoding manner is hard-decision decoding; or the first decoding manner is hard-decision decoding, and the second decoding manner is soft-decision decoding.

Optionally, the apparatus 1600 further includes a synchronization module 1650, configured to determine the FEC codeword boundary in the data sequence in a self-synchronization manner.

Optionally, the preset sequence is an FS, or the preset sequence is in an AM.

Optionally, the data sequence is obtained based on an Ethernet signal received through an Ethernet interface.

Optionally, the Ethernet signal is a Terabit Ethernet signal.

The data processing apparatus 1600 provided in this embodiment of this application may alternatively be implemented by using an application-specific integrated circuit (application-specific integrated circuit, ASIC) or a programmable logic device (programmable logic device, PLD). The PLD may be a complex programmable logical device (complex programmable logical device, CPLD), a field-programmable gate array (field-programmable gate array, FPGA), generic array logic (generic array logic, GAL), or any combination thereof. Some steps of the data processing method provided in the foregoing method embodiments may alternatively be implemented by using software. When some steps of the data processing method provided in the foregoing method embodiments are implemented by using software, some modules in the data processing apparatus 1600 are software modules. Optionally, the obtaining module 1610, the decoding module 1620, and the synchronization module 1650 are all hardware modules, and the searching module 1630 and the deletion module 1640 are all software modules.

In another implementation, the apparatus includes a memory, a processor, and a communication interface. The communication interface includes an Ethernet interface. The memory is configured to store a computer program. The processor is configured to execute the computer program stored in the memory, to cause the apparatus to perform related steps in the method embodiment shown in FIG. 11 or FIG. 12, for example, the apparatus is caused to perform steps S1103 and S1105.

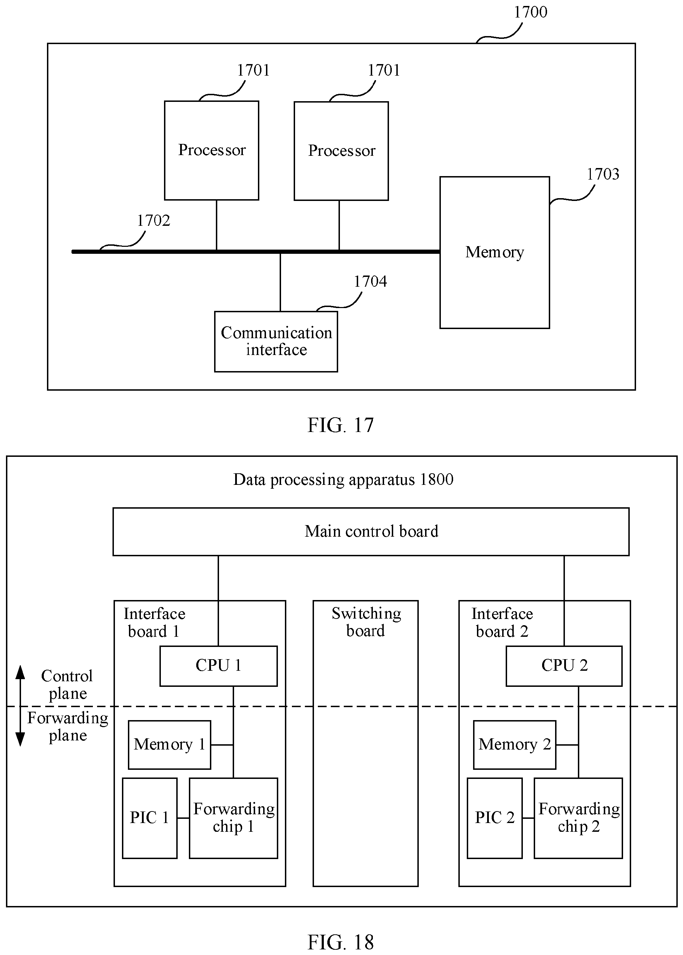

In an embodiment, FIG. 17 is a diagram of another data processing apparatus 1700 according to an embodiment of this application. The apparatus 1700 may be a forwarding device, a user terminal device, or a server device. The apparatus 1700 includes at least one processor 1701 (two processors 1701 are used as an example for description in FIG. 17), a communication bus 1702, a memory 1703, and at least one communication interface 1704. The at least one processor 1701, the memory 1703, and the at least one communication interface 1704 are connected through the communication bus 1702. The at least one processor 1701, the memory 1703, and the at least one communication interface 1704 may alternatively be connected in another connection manner other than the communication bus 1702.

The memory 1703 is configured to store a computer program for performing the technical solutions of this application and the processor 1701 controls execution. The computer program stored in the memory 1703 includes but is not limited to program code, program instructions, data, and the like. The memory 1703 may be a read-only memory (read-only memory, ROM) or another type of static storage device capable of storing static information and instructions, or a random access memory (random access memory, RAM) or another type of dynamic storage device capable of storing information and instructions, or may be a non-volatile random access memory (non-volatile random access memory, NVRAM), a programmable read-only memory (programmable read-only memory, PROM), an erasable programmable read-only memory (erasable programmable read-only memory, EPROM), an electrically erasable programmable read-only memory (electrically erasable programmable read-only memory, EEPROM), a compact disc read-only memory (compact disc read-only memory, CD-ROM) or another compact disc storage, an optical disc storage (including a compact disc, a laser disc, an optical disc, a digital versatile disc, a Blu-ray disc, or the like), a magnetic disk storage medium or another magnetic storage device, or any other medium capable of carrying or storing expected program code in a form of instructions or a data structure and capable of being accessed by a computer, but is not limited thereto. The memory 1703 may exist independently, and is connected to the processor 1701 through the communication bus 1702. Alternatively, the memory 1703 may be integrated with the processor 1701. This is not limited in this embodiment of this application.

The processor 1701 may be a general-purpose processor or a dedicated processor. The general-purpose processor is a processor that performs a specific step and/or operation by reading and executing a computer program stored in a memory (for example, the memory 1703). In a process of performing the foregoing step and/or operation, the general-purpose processor may use the computer program stored in the memory (for example, the memory 1703). The stored computer program may be executed to implement related functions of the foregoing searching module 1630, the deletion module 1650, and the like. The general-purpose processor is, for example, but not limited to, a central processing unit (central processing unit, CPU). The dedicated processor is a processor specially designed to perform a specific step and/or operation. The dedicated processor is, for example, but not limited to, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The processor 1701 may implement or execute various logical blocks, modules, and circuits described with reference to the content disclosed in embodiments of this application. Alternatively, the processor 1701 may be a combination of processors implementing a computing function, for example, a combination of one or more microprocessors, or a combination of a DSP and a microprocessor. The processor may be configured to: find a preset sequence in at least one decoded codeword, where the at least one decoded codeword is obtained by performing FEC decoding on at least one FEC codeword in a data sequence, and the data sequence includes a plurality of FEC codewords; and if a preset condition is satisfied, delete, from the data sequence based on a position of the found preset sequence in the data sequence, a padding sequence related to the preset sequence, where the preset condition includes: a quantity of preset sequences included in n codewords in the at least one decoded codeword reaches a first threshold, where n is a positive integer, and an interval between adjacent codewords in the n codewords is a periodicity at which the preset sequence appears in the data sequence.

The communication bus 1702 is configured to transfer information between the processor 1701, the communication interface 1704, and the memory 1703. The communication bus 1702 may be a peripheral component interconnect (peripheral component interconnect, PCI) bus, an extended industry standard architecture (extended industry standard architecture, EISA) bus, or the like. The communication bus 1702 may be classified as an address bus, a data bus, a control bus, or the like. For ease of representation, only one bold line represents the bus in FIG. 17, but this does not mean that there is only one bus or only one type of bus.

The communication interface 1704 includes interfaces such as an input/output (input/output, I/O) interface, a physical interface, a logical interface, and the like that are configured to implement interconnection between devices in the apparatus 1700, and that are configured to implement interconnection between the apparatus 1700 and another communication device. The physical interface may be an Ethernet (Ethernet) interface, a fast Ethernet (fast Ethernet, FE) interface, a gigabit Ethernet (gigabit Ethernet, GE) interface, a Terabit Ethernet (Terabit Ethernet, TbE) interface, a 400G Ethernet interface, an asynchronous transfer mode (asynchronous transfer mode, ATM) interface, or the like, and is configured to implement interconnection between the apparatus 1700 and another device. The logical interface is an internal interface of the apparatus 1700, and is configured to implement interconnection between devices in the apparatus 1700. It is easily understood that the communication interface 1704 is used by the apparatus 1700 to communicate with another device. For example, the communication interface 1704 is used by the apparatus 1700 to send and receive an Ethernet signal between the apparatus 1700 and another device or a communication network. The communication interface 1704 may be any apparatus such as a transceiver. The communication network may be an Ethernet, an optical transport network (optical transport network, OTN), a secret private network (secret private network, SPN), a fiber channel (fiber channel), an infiniband (infiniband), or the like.

During specific implementation, in an embodiment, the apparatus 1700 includes a plurality of processors 1701, and each of plurality of the processors 1701 may be a single-core (single-CPU) processor, or may be a multi-core (multi-CPU) processor. The processor herein may be one or more devices, circuits, and/or processing cores configured to process data (for example, computer program instructions).

In a specific embodiment, the communication interface 1704 in the apparatus 1700 is configured to receive an Ethernet signal carrying a data sequence. The processor 1701 is configured to: obtain the data sequence in the Ethernet signal, perform FEC decoding on at least one FEC codeword in the data sequence to obtain at least one decoded codeword, and search for a preset sequence in the at least one decoded codeword. For a detailed processing process of the processor 1701, refer to related descriptions in the method embodiments shown in FIG. 11 and FIG. 12. Details are not described herein again.

In another embodiment, FIG. 18 is a diagram of still another data processing apparatus 1800 according to an embodiment of this application. The apparatus 1800 may be a forwarding device, for example, a switch or a router. As shown in FIG. 18, the apparatus 1800 includes a main control board and one or more interface boards. The main control board is communicatively connected to the interface board. The main control board is also referred to as a main processing unit (main processing unit, MPU) or a route processor card (route processor card). The main control board is responsible for controlling and managing each component in the apparatus 1800, including route computation, device management, and function maintenance. The interface board is also referred to as a line processing unit (line processing unit, LPU) or a line card (line card). The interface board is configured to forward data. In some embodiments, the apparatus 1800 may also include a switching board, the switching board is communicatively connected to the main control board and the interface board, the switching board is configured to forward data between the interface boards, and the switching board may also be referred to as a switch fabric unit (switch fabric unit, SFU). The interface board includes a central processing unit, a memory, a forwarding chip, and a physical interface card (physical interface card, PIC). The central processing unit is separately communicatively connected to the memory, the forwarding chip, and the physical interface card. The memory is configured to store a forwarding table. The forwarding chip is configured to forward a received data frame based on the forwarding table stored in the memory. If a destination address of the data frame is an address of the apparatus 1800, the data frame is sent to the CPU for processing. If the destination address of the data frame is not the address of the apparatus 1800, a next hop and an outbound interface corresponding to the destination address are found in the forwarding table based on the destination address, and the data frame is forwarded to the outbound interface corresponding to the destination address. The forwarding chip may be a network processor (network processor, NP). The PIC is also referred to as a subcard, and may be mounted on the interface board and responsible for converting an optical or electrical signal into a data frame, checking validity of the data frame, and then forwarding the data frame to the forwarding chip for processing. In some embodiments, the central processing unit may also perform a function of a forwarding chip, for example, implement software forwarding based on a general-purpose CPU, so that no forwarding chip is required in the interface board. A communication connection between the main control board, the interface board, and the switching board may be implemented through a bus. The forwarding chip may be implemented by using an ASIC or an FPGA.

Logically, the apparatus 1800 includes a control plane and a forwarding plane. The control plane includes the main control board and the central processing unit, and the forwarding plane includes components for performing forwarding, such as the memory, the PIC, and the NP. The control plane performs functions such as a function of a router, generating a forwarding information table, processing signaling and protocol packets, and configuring and maintaining a status. The control plane delivers the generated forwarding information table to the forwarding plane. On the forwarding plane, the NP searches the forwarding information table delivered by the control plane to forward a packet received by the PIC of the apparatus 1800. The forwarding table delivered by the control plane may be stored in the memory. In some embodiments, the control plane and the forwarding plane may be completely separate and not on a same device.

In a specific embodiment, the interface board is configured to: receive an Ethernet signal, obtain a data sequence from the Ethernet signal, where the data sequence includes a plurality of FEC codewords, and perform FEC decoding on at least one FEC codeword in the data sequence to obtain at least one decoded codeword. For a specific process, refer to the descriptions in S1101 and S1102. The main control board is configured to search for a preset sequence in the at least one decoded codeword. For a specific process, refer to the descriptions in S1103. Details are not described herein again.

In a possible implementation, an inter-process communication protocol (inter-process communication, IPC) channel is established between the main control board and the interface board, and the main control board and the interface board communicate with each other through the IPC channel.

Based on a same inventive concept, an embodiment of this application provides a chip, configured to perform the method provided in the embodiment shown in FIG. 11 or FIG. 12.

Optionally, the chip is a chip in a host chip or an optical module. The chip includes a programmable logic circuit and/or program instructions.

Optionally, the chip may be used in a concatenated FEC encoding scenario and a non-concatenated FEC encoding scenario. Specifically, the concatenated FEC encoding includes outer FEC encoding and inner FEC encoding, and corresponding FEC decoding includes inner FEC decoding and outer FEC decoding. The chip provided in this embodiment of this application is configured to perform inner FEC decoding and/or outer FEC decoding. The non-concatenated FEC encoding scenario includes one layer of FEC encoding, and corresponding FEC decoding includes one layer of FEC decoding. The chip provided in this embodiment of this application is configured to perform the layer of FEC decoding.

Based on a same inventive concept, an embodiment of this application provides a computer-readable storage medium. The computer-readable storage medium stores a computer program. When the computer program is executed (for example, executed by a forwarding device, a user terminal device, a server device, a host chip, an optical module, or a chip in the optical module), steps of the method embodiments shown in FIG. 11 and FIG. 12 are implemented, for example, steps S1103 and S1105 are implemented.

Based on a same inventive concept, an embodiment of this application provides a computer program product. The computer program product includes a program or code. When the program or code is executed (for example, executed by a forwarding device, a user terminal device, a server device, a host chip, an optical module, or a chip in the optical module), steps of the method embodiments shown in FIG. 11 and FIG. 12 are implemented, for example, steps S1103 and S1105 are implemented.

Based on a same inventive concept, an embodiment of this application provides a communication system. The communication system includes an optical module and a host. The optical module is communicatively connected to the host. For example, the optical module is inserted into the host, and the optical module is configured to perform the method embodiments shown in FIG. 11 and FIG. 12.

Optionally, the host is a forwarding device, a user terminal device, or a server device. The forwarding device is a router or a switch.

Optionally, the communication system is a network system like an Ethernet, an optical transport network (optical transport network, OTN), a secret private network (secret private network, SPN), a fiber channel (fiber channel), or an infiniband (infiniband).

According to the technical solutions provided in embodiments of this application, because the optical module is configured to perform the method embodiments shown in FIG. 11 and FIG. 12, efficiency, precision, and reliability of searching for a preset sequence in a data sequence can be improved by performing the method embodiments shown in FIG. 11 and FIG. 12 by the optical module. Therefore, the host connected to the optical module can obtain a corresponding benefit, for example, efficiency and reliability of processing the data sequence by the host are improved.

All or some of the foregoing embodiments may be implemented by using software, hardware, firmware, or any combination thereof. When embodiments are implemented by using the software, all or a part of embodiments may be implemented in a form of a computer program product. The computer program product includes one or more computer instructions. When the computer program instructions are loaded and executed on a computer, all or some of the procedures or functions according to embodiments of this application are generated. The computer may be a general-purpose computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial optical cable, an optical fiber, or a digital subscriber line) or wireless (for example, infrared, radio, or microwave) manner. The computer-readable storage medium may be any usable medium accessible by the computer, or includes a data storage apparatus, such as a server or a data center, integrating one or more usable media. The usable medium may be a magnetic medium (for example, a floppy disk, a hard disk, or a magnetic tape), an optical medium, a semiconductor medium (for example, a solid-state drive), or the like.

It should be understood that in this application, the term "at least one" means one or more, and the term "a plurality of" means two or more than two. In this application, unless otherwise specified, the symbol "/" usually means "or". For example, A/B may represent A or B. The term "and/or" in this application describes only an association relationship for describing associated objects and represents that three relationships may exist. For example, A and/or B may represent the following three cases: Only A exists, both A and B exist, and only B exists. For ease of clear description, in this application, words such as "first", "second", and "third" are used to distinguish between same items or similar items whose functions and purposes are basically the same. A person skilled in the art may understand that the words such as "first", "second", and "third" do not limit a quantity and an execution sequence.

Different types of embodiments such as the method embodiments and the apparatus embodiments provided in embodiments of this application may be cross-referenced. This is not limited in embodiments of this application. A sequence of operations in the method embodiments provided in embodiments of this application can be properly adjusted, and the operation can be correspondingly added or deleted based on a situation. Any variation method that can be readily figured out by a person skilled in the art within the technical scope disclosed in this application shall fall within the protection scope of this application. Therefore, details are not described again.

In the corresponding embodiments provided in this application, it should be understood that the disclosed apparatus and the like may be implemented in other composition manners. For example, the described apparatus embodiments are merely examples. For example, division into the units is merely logical function division and may be another division manner during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic or other forms.

The units described as separate parts may or may not be physically separate, and parts described as units may or may not be physical units, may be located in one position, or may be distributed on a plurality of network nodes. Some or all of the units may be selected based on actual requirements to achieve the objectives of the solutions in embodiments.

The foregoing descriptions are merely example implementations of this application, but are not intended to limit the protection scope of this application. Any equivalent modification or replacement readily figured out by a person skilled in the art within the technical scope disclosed in this application shall fall within the protection scope of this application. Therefore, the protection scope of this application shall be subject to the protection scope of the claims.

## Claims

1. A data processing method, wherein the method comprises:
obtaining a data sequence, wherein the data sequence comprises a plurality of forward error correction FEC codewords;
performing FEC decoding on at least one FEC codeword in the data sequence to obtain at least one decoded codeword; and
finding a preset sequence in the at least one decoded codeword.

2. The method according to claim 1, wherein
the preset sequence is a sequence that periodically appears in the data sequence.

3. The method according to claim 2, wherein the method comprises:
if a preset condition is satisfied, deleting, from the data sequence based on a position of the found preset sequence in the data sequence, a padding sequence related to the preset sequence, wherein the preset condition comprises: a quantity of preset sequences comprised in n codewords in the at least one decoded codeword reaches a first threshold, wherein n is a positive integer, and an interval between adjacent codewords in the n codewords is a periodicity at which the preset sequence appears in the data sequence.

4. The method according to claim 2 or 3, wherein the method comprises:
if an unlock condition is satisfied, re-searching for an FEC codeword boundary in the data sequence, wherein the unlock condition comprises: a quantity of codewords that are in m codewords in the at least one decoded codeword and that do not comprise the preset sequence reaches a second threshold, wherein m is a positive integer, and an interval between adjacent codewords in the m codewords is a periodicity at which the preset sequence appears in the data sequence.

5. The method according to any one of claims 2 to 4, wherein
the performing FEC decoding on the at least one FEC codeword in the data sequence to obtain the at least one decoded codeword comprises: performing FEC decoding on the plurality of FEC codewords to obtain a plurality of decoded codewords; and
the finding the preset sequence in the at least one decoded codeword comprises: finding the preset sequence in the plurality of decoded codewords.

6. The method according to any one of claims 2 to 4, wherein the performing FEC decoding on the at least one FEC codeword in the data sequence to obtain the at least one decoded codeword, and the finding the preset sequence in the at least one decoded codeword comprise:
performing FEC decoding on a first FEC codeword in the data sequence to obtain a decoded first codeword; and
if the decoded first codeword does not comprise the preset sequence, continuing to perform FEC decoding on an FEC codeword that is in the data sequence and that is after the first FEC codeword, until a 1^{st} preset sequence is found.

7. The method according to claim 6, wherein the performing FEC decoding on the at least one FEC codeword in the data sequence to obtain the at least one decoded codeword, and the finding the preset sequence in the at least one decoded codeword further comprise:
if the decoded first codeword comprises the preset sequence, performing FEC decoding on a second FEC codeword that is in the data sequence and that is after the first FEC codeword to obtain a decoded second codeword, wherein an interval between the second FEC codeword and the first FEC codeword is a periodicity at which the preset sequence appears in the data sequence; and
attempting to search for the preset sequence in the decoded second codeword.

8. The method according to claim 6 or 7, wherein
the performing FEC decoding on the at least one FEC codeword in the data sequence comprises:
performing FEC decoding on the first FEC codeword in the data sequence in a first decoding manner; and
performing, in a second decoding manner, FEC decoding on a candidate FEC codeword that is in the data sequence and that is after the first FEC codeword.

9. The method according to claim 8, wherein
the first decoding manner is soft-decision decoding, and the second decoding manner is hard-decision decoding; or
the first decoding manner is hard-decision decoding, and the second decoding manner is soft-decision decoding.

10. The method according to any one of claims 1 to 9, wherein before performing FEC decoding on the at least one FEC codeword in the data sequence, the method further comprises: determining the FEC codeword boundary in the data sequence in a self-synchronization manner.

11. The method according to any one of claims 1 to 10, wherein
the preset sequence is a frame sequence FS, or the preset sequence is in an alignment marker AM.

12. The method according to any one of claims 1 to 11, wherein
the method is performed by a host chip, an optical module, or a chip in the optical module.

13. The method according to any one of claims 1 to 12, wherein
the data sequence is obtained based on an Ethernet signal received through an Ethernet interface.

14. The method according to claim 13, wherein
the Ethernet signal is a Terabit Ethernet signal.

15. A data processing apparatus, wherein the apparatus is configured to perform the method according to any one of claims 1 to 14.

16. The apparatus according to claim 15, wherein the apparatus comprises an Ethernet interface.

17. The apparatus according to claim 15 or 16, wherein the apparatus is any one of the following: a forwarding device, a user terminal device, a server device, a host chip, an optical module, or a chip in the optical module.

18. A chip, wherein the chip is configured to perform the method according to any one of claims 1 to 14.

19. The chip according to claim 18, wherein the chip is a chip in a host chip or an optical module.

20. A computer-readable storage medium, wherein the computer-readable storage medium stores a computer program; and when the computer program is executed, a preset sequence is found in a decoded codeword, wherein the decoded codeword is obtained by performing FEC decoding on a forward error correction FEC codeword in a data sequence, and the data sequence comprises a plurality of FEC codewords.

21. A communication system, comprising an optical module and a host, wherein the optical module is configured to perform the method according to any one of claims 1 to 14.
